(19) Europäisches Patentamt
European Patent Office
Office européen des brevets

(11) EP 1 768 119 A2

(12) # EUROPEAN PATENT APPLICATION

(43) Date of publication:
**28.03.2007 Bulletin 2007/13**

(51) Int Cl.:
***G11B 7/24*** *(2006.01)*

(21) Application number: **06254427.5**

(22) Date of filing: **24.08.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **25.08.2005 JP 2005244294**
**25.08.2005 JP 2005244275**
**15.12.2005 JP 2005362401**

(71) Applicant: **FUJIFILM Corporation**
**Minato-ku**
**Tokyo (JP)**

(72) Inventor: **YANAGIHARA, Naoto**
**c/o Fuji Phote Film Co., Ltd.**
**Shizuoka (JP)**

(74) Representative: **Stevens, Jason Paul**
**Frank B. Dehn & Co.**
**St Bride's House**
**10 Salisbury Square**
**London EC4Y 8JD (GB)**

(54) **Optical information recording medium, optical information recording method and optical information reproducing method**

(57) The present invention provides an optical recording medium, which contains a substrate (42); and a recording layer (41) disposed on the substrate, wherein the recording layer is subjected to recording of information using holography, wherein the recording layer contains a gas generating substance encapsulated in minute receptacles, and wherein the gas generating substance generates gas upon radiation of light. The present invention also provides an optical recording method, and an optical information reproducing method using such the optical recording medium.

FIG. 2

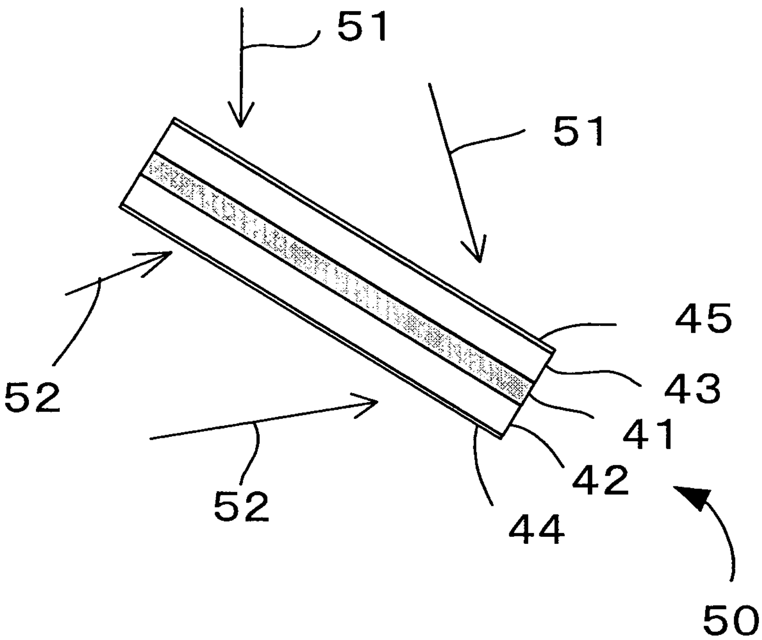

**Description**

BACKGROUND OF THE INVENTION

Field of the invention

The present invention relates to an optical information recording medium for recording information using holography, an optical information recording method, and an optical information reproducing method, with excellent sensitivity, resolution, and diffractive efficiency, etc., without damaging storage stability of a raw recording material, i.e. storage stability before use, which forms hologram.

Description of the Related Art

An optical information recording method for recording information on an optical recording medium by holography generally utilizes optical interference inside the optical information recording medium between reference light and information light (object light) with image information to thereby produce an interference image (interference fringes) that can be recorded on the optical information recording medium. An example of this kind of optical information recording method is a reflective optical information recording method shown in FIG. 3. With this method, information is recorded in the following procedure. The light from a first light source 61 is split into two, one forming an information light 51 that passed through a half mirror 64, and another forming reference light 52 reflected by the half mirror 64. The information light 51 is expanded through a mirror 66 and a beam expander 68, and is irradiated to the recording layer of the optical information recording medium 50. The reference light 52 is expanded through a mirror 65 and a beam expander 67, and is irradiated to the opposite side of the recording layer. In this way the information light 51 and reference light 52 create an interference image, which is recorded on the recording layer as optical information. Even when the reference light 52 is applied in the same direction as the information light 51, an interference image is also created for recording, as in a case where the reference light 52 is applied in a different direction. A technology in which the information light 51 and reference light 52 are applied in such a way that the optical axis of the information light 51 is collinear with that of the reference light 52 is called the "collinear technology." An interference image is also created in this scheme, too. Reproduction of the recorded optical information is performed by applying another reference light to the optical information recording medium from the direction for recording. In this way diffracted rays are created from the interference image and the optical information is reproduced by receiving them.

As a recording material for recording the interference fringes as these optical information, recording materials of high sensitivity are proposed, for example, halogenated silver, photopolymers, gas generating substances, surface-relieved materials, photorefractive materials, photochromic materials, etc. Amongst of them, the gas generating substances are suitable for refractive-index modulation hologram wherein the contrast (darkness-brightness) of the interference fringes are recorded as the contrast of the refractive index, since the gas generating substances are capable of generating (gas) bubbles on radiation, and causes variations of the refractive index between the bubbles and the materials forming the recording layer. Since the gas generating substances have merits such that the interference fringes can be excellently recorded even with the small amount of generated gas which increases the refractivity, and the resolutions are improved thereby, such the gas generating substances are commonly used as a recording material for the refractive-index modulation hologram.

Japanese Patent Application Laid-Open (JP-A) No.05-72727 proposes an optical recording medium which has a recording layer containing diazonium salt as the gas generating substance.

The diazonium salt mentioned above is highly sensitive, but also unstable material. In the case of the recording layer containing the diazonium salt, as the diazonium salt is directly dispersed in the binder of the recording layer, there are problems related to storage stability of the raw materials such that the optical recording medium needs to be refrigerated to store before use.

Moreover, it is necessary to control the diameter of generated gas bubble smaller than the wavelength of reproduction light. In the case of the aforementioned gas generating substance, the gas bubbles generated by radiation are however conjugated to each other in the recording layer. Therefore, the diameter of the gas bubbles become larger than the wavelength of the reproduction light. In such the case, the reproduction light is scattered at the time of radiation, and this causes signal errors. Therefore, such the gas generating substance has problems in the practical use.

Therefore, there have not been provided, but desired, an optical information recording medium and an optical information recording method, which utilize variations of refractive-index caused by a gas generating substance, without adversely affecting properties of hologram such as storage stability of raw materials, and which have excellent sensitivity, resolution and diffractive efficiency.

SUMMARY OF THE INVENTION

The present invention is aimed at solving the problems in the related art, and achieving the following objects. It is an object of the present invention to provide an optical information recording medium, which has a recording layer containing a gas generating substance, with high sensitivity, excellent storage stability of a recording material before use, resolution, and diffractive efficiency, while maintaining high resolution at the same time. It is also another object of the present invention to provide an optical recording method, and an optical reproducing method using such the optical recording medium.

The means for solving above problems are as follows:

<1> An optical information recording medium, comprising:

a substrate; and
a recording layer disposed on the substrate, the recording layer being subjected to recording of information using holography,
wherein the recording layer comprises a gas generating substance encapsulated in a minute receptacle, and wherein the gas generating substance generates gas upon radiation of light.

<2> The optical information recording medium according to <1>, wherein the recording layer has an oxygen permeability coefficient of 0.3ml $\cdot 25\mu m/m^2 \cdot 24h$ atm or less under the condition of a temperature at 23°C and a relative humidity at 50%.
According to the optical information recording medium described in <2>, the recording layer has the oxygen permeability coefficient of 0.3ml$\cdot 25\mu m/m^2 \cdot 24h$ atm or less under the condition of a temperature at 23°C and a relative humidity at 50%. Since the oxygen permeability coefficient of the recording layer is kept low, the conjunction of gas bubbles does not occur when information light and reference light are irradiated to an area to be recorded, and the gas generation substance contained in such the area generates gas bubbles upon the radiation. Therefore, signal errors due to light diffusion can be prevented at the time of reproducing the information.
<3> The optical information recording medium according to one of <1> or <2>, wherein the gas generating substance is a refractive-index changeable material.
According to the optical information recording medium described above <3>, the recording layer contains the minute receptacles, each encapsulating the refractive-index changeable material. Upon radiation of the information light and the reference light to an area to be recorded, the irradiated information light and reference light form an interference image, i.e., interference fringes, and the refractive-index changeable material contained in such the area generates gas to thereby lower the refractive-index of the bright area formed by the interference fringes. Therefore, the refractive-index contrast with the dark area is increased, and the resolution is improved.
<4> The optical information recording medium according to <3>, wherein the refractive-index changeable material is a diazonium salt compound.
<5> The optical information recording medium according to any one of <1> to <4>, wherein the minute receptacle is a microcapsule.
<6> The optical information recording medium according to <5>, wherein a diameter of the microcapsule is the same length to or smaller than a wavelength of the light.
<7> The optical information recording medium according one of <5> and <6>, wherein a diameter of the microcapsule is $0.4\mu m$ or less.
<8> The optical information recording medium according to any one of <4> to <7>, wherein the diazonium salt compound comprises at least one substituent which is an electron donating group having a negative value of Hammett $\sigma_p$.
<9> The optical information recording medium according to any one of <1> to <8>, wherein the recording layer further comprises a binder resin, and a content of the binder resin is 10% by mass to 95% by mass with respect to the total solids mass of the recording layer.
<10> An optical information recording method, comprising;
irradiating information light and reference light to the optical recording medium according to any one of <1> to <9> in a manner such that an optical axis of the information light and an optical axis of the reference light become collinear.
<11> The optical information recording method according to <10>, further comprising, after the aforementioned irradiating the information light and the reference light, irradiating incoherent light so as to decompose the remained gas generating substance in the recording layer.
<12> An optical information reproducing method, comprising;
irradiating reference light to an interference image formed in a recording layer of an optical information recording medium so as to reproduce recorded information corresponding to the interference image,

wherein the interference image is formed by the optical information recording method according to one of <10> to <11>.

<13> The optical information reproducing method according to <12>, wherein the reference light for reproducing is irradiated at the same angle as an incident angle of the reference light at the time of recording, so as to reproduce the recorded information.

According to the present invention, the problems in the related art can be solved, and there can be provided: an optical information recording medium, which has a recording layer containing a gas generating substance, with high sensitivity, excellent storage stability of a recording material before use, resolution, and diffractive efficiency, while maintaining high resolution at the same time; an optical recording method using such the optical recording medium; and an optical reproducing method using such the optical recording medium.

## BRIEF DESCRIPTION OF THE DRAWINGS

FIG. 1 is a conceptual illustration showing an example of an optical recording method.

FIG. 2 is a partial vertical illustration of an example of the optical recording medium in the present invention.

FIG. 3 is a conceptual illustration showing an example of an optical recording method.

FIG. 4 is a conceptual vertical illustration showing an example of a structure of an optical recording medium.

FIG. 5 is a conceptual vertical illustration showing an example of the optical recording medium according to Operative Example 1 of the present invention.

FIG. 6 is a conceptual vertical illustration showing an example of the optical recording medium according to Operative Example 2 of the present invention.

FIG. 7 is a conceptual vertical illustration showing an example of the optical recording medium according to Operative Example 3 of the present invention.

FIG. 8 is a conceptual vertical illustration showing an example of the optical recording medium according to Operative Example 4 of the present invention.

FIG. 9 is a conceptual vertical illustration showing an example of the optical recording medium according to Operative Example 5 of the present invention.

FIG. 10 is a conceptual vertical illustration showing an example of the optical recording medium according to Operative Example 6 of the present invention.

FIG. 11 is an explanation showing an example of an optical system accompanied with the optical recording medium of the present invention.

FIG. 12 is a block flowchart showing an example of the whole mechanism of the optical recording and reproducing apparatus of the present invention.

FIG. 13 is a graph showing a reflectivity of the filter for the optical recording medium of the present invention with incident light irradiated from the normal direction (at 0°) of the filter.

FIG. 14 is a graph showing a reflectivity of the filter for another optical recording medium of the present invention with incident light from the normal direction (at 0°) of the filter.

FIG. 15 is a graph showing a reflectivity of the filter that is a laminate of three cholesteric liquid crystal layers with incident light from the normal direction (at 0°) of the filter.

FIG. 16 is a graph showing a reflectivity of the filter that is a laminate of two cholesteric liquid crystal layers with incident light from the normal direction (at 0°) of the filter.

## DESCRIPTION OF THE PREFERRED EMBODIMENTS

(Optical recording medium)

An optical recording medium of the present invention contains a substrate, a recording layer on which information is recorded using holography, and other layers appropriately selected depending on the intended purpose.

The optical recording medium can have any embodiments such as a relatively thin flat hologram which is capable of recording two-dimensional information, a voluminous hologram which is capable of recording a large volume of information such as three-dimensional image, and the like. These can be of transparent type or reflective type. The recording method of the hologram is not particularly limited, and is for example any one of amplitude hologram, phase hologram, blazed hologram, or multi-element amplitude hologram.

The optical recording medium of the present invention is available at least in two embodiments. The first embodiment of the optical recording medium contains at least one substrate, and a recording layer disposed on the substrate, and the first embodiment is utilized for a general hologram recording in which information light and reference

light are irradiated from mutually different directions. The second embodiment of the optical recording medium contains a first substrate, a second substrate, a recording layer disposed above the second substrate, and a filter layer disposed between the second substrate and the recording layer, and the second embodiment is utilized for a collinear hologram recording in which information light and reference light are irradiated in a manner such that the optical axis of the information light and the optical axis of the reference light become collinear.

The first embodiment and the second embodiment are sequentially explained hereinafter.

<<First embodiment>>

The first embodiment of the optical recording medium is applied for general hologram recording method. There is not any particular restriction for the layer structure thereof, and the layer structure is appropriately selected depending on the intended purpose. For example, there are layer structures available such as the one having a substrate, and a laminate of one or more a recording layers disposed on the substrate, and the one having a substrate 42, a substrate 43, a recording layer 41 disposed between the substrates 42 and 43, and reflection inhibiting layers 44 and 45, respectively disposed on the outer surfaces of the substrates 42 and 43, as shown in FIG. 2. Moreover, the aforementioned layer structure may further contains a gas barrier layer disposed between the recording layer 41 and the substrate 42, as well as between the recording layer 41 and the substrate 43. Furthermore, a protective layer can be disposed on the surfaces of the reflection inhibiting layers 44 and 45.

<Recording layer>

On the recording layer, information can be recorded using holography. A material for the recording layer is selected from materials which change optical properties such as absorption index or refractive-index, depending on intensity of radiation, upon the radiation of electromagnetic wave having a certain wavelength (y-ray, X-ray, ultraviolet ray, visible ray, infrared ray, and radio wave, etc.).

Such the material for the recording layer contains a gas generating substance which generates gas upon radiation, a photosensitive resin, a binder resin, and other components appropriately selected depending on the intended purpose. Moreover, the recording layer contains the gas generating substance in the form that it is encapsulated in minute receptacles.

-Oxygen permeability coefficient-

The oxygen permeability coefficient of the recording layer is 0.3ml·25μm/m$^2$·24h·atm or less under the condition of 23°C and 50% RH. By maintaining the oxygen permeability coefficient of the recording layer within the aforementioned range, diameters of the gas bubbles generated within the recording layer are controlled to be 0.4 μm or less at the time of the recording. If the diameters of the generated gas bubbles are 0.4 μm or less, light for reproducing is not adversely affected at the time of reproducing.

In case the oxygen permeability coefficient is over 0.3ml ·25μm/m$^2$ ·24h atm, upon radiation of light for recording, the gas generating substance contained in the recording layer generates gas, the generated gas bubbles are conjugated with the gas bubbles already present in the recording layer, and the sizes of the conjugated gas bubbles become large. If the diameters of these enlarged gas bubbles become bigger than a wavelength of light for reproduction, the light is diffused by the bubbles, and thus signal errors occur. Moreover, storage stability of a raw recording material for the recording layer deteriorates in this case, and this leads adverse effects on the resolution or the like.

On arranged the gas barrier layer, there is not any particular restriction for the oxygen permeability coefficient of the gas barrier layer, it is appropriately selected depending on the intended purpose, and for example, it is preferred at 0.1ml·25μm/m$^2$·24h ·atm or less under the condition of 23°C and 50% RH. In the case where the oxygen permeability coefficient of the gas barrier layer is controlled at 0.1ml ·25μm/m$^2$ ·24h atm or less under the condition of 23°C and 50% RH, the diameters of the generated gas bubbles can preferably be controlled to be 0.4 μm or less.

There is not any particular restriction for the measuring method of the oxygen permeability coefficient, it is appropriately selected depending on the intended purpose, and for example, a differential pressure method and an equal pressure method both described in JIS K 7126 (an examination method for gas permeation of the plastic film and plastic sheet), etc., are available.

The differential pressure method mentioned above is a method wherein a container is separated into two spaces by a test piece, one space is kept vacuumed (low pressure space), a test gas is introduced in the other space (high pressure space), and a gas permeation of the test piece is measured with an increased pressure within the low pressure space. This method does not restrict types of gas applicable for the test.

The equal pressure method mentioned above is a method wherein a container is separated into two spaces by a test piece, an oxygen gas is introduced in one space, a nitrogen gas is introduced in the other space, and the

oxygen gas passed through the test piece is detected by an oxygen detector.

Amongst of them, the equal pressure method is preferred in view of that the oxygen permeability coefficient of the recording layer for use in the present invention can be appropriately measured.

There is not any particular restriction for the measuring device of the oxygen permeability coefficient, it is appropriately selected depending on the intended purpose, and for example, an equal pressure gas permeation detector, an oxygen permeability detector, gas permeability detector, etc., are available.

-Gas generating substance-

There is not any particular restriction for the gas generating substance, it is appropriately selected depending on the intended purpose, and for example, a refractive-index changeable material, etc., is available.

The refractive-index changeable material is applied for the refractive-index modulation hologram which records a brightness/darkness contrast of interference fringes generated by information light and reference light as fringes of the refractive-index contrasts.

The refractive-index changeable material is contained in the recording layer, and changes the refractive-index of the recording layer upon radiation of light. The refractive-index changeable material is preferably such a material that generates gas bubbles within the recording layer upon radiation of light to thereby lower the refractive-index of the recording layer. Namely, the refractive-index of the bubble itself is lower than other components contained in the recording layer, and thus the refractive-index of the recording layer at where the light is irradiated is remarkably lowered than that of the area at where the light is not irradiated. For example, in case the refractive-index of the recording layer is 1.5, since the refractive-index of the generated bubble itself is 1.0, the refractive-index of the entire area at where the light is irradiated is remarkably lowered, for example around 1.2.

On the other hand, in the case where the recording layer is formed of a photopolymer without containing the refractive-index changeable material (gas generating substance), the refractive-index of the light irradiated area is remained at around 1.4, and thus the refractive-index thereof is not sufficiently lowered. The refractive-index changeable material for use in the present invention is suitably applicable for the refractive-index modulation hologram which records the brightness/darkness contrast of the interference fringes as refractive-index contrasts.

There is not any particular restriction for the refractive-index changeable material, it is appropriately selected depending on the intended purpose, and for example, a diazonium salt compound, etc., are available.

-Minute Receptacle-

The minute receptacle mentioned above encapsulates the diazonium salt compound therein so as to separate the diazonium salt compound from other components in the recording layer, and thus the storage stability of the raw material of the recording layer for use in the present invention can be improved. There is not any particular restriction for the minute receptacle, but a microcapsule is preferred in view of the productivity.

There is not any particular restriction for the size of the microcapsule, and it is appropriately selected depending on the intended purpose, provided that the diameter of the microcapsule is the same length to or smaller than a wavelength of the light used for reproduction, i.e. reproduction light. For example, the diameter of the microcapsule is preferably 0.4 μm or less.

In case where the diameter of the microcapsule is more than 0.4 μm, on reproducing the recorded information of the optical recording medium, the reproduction light irradiated on the optical recording medium might be diffused to thereby cause reproduction errors.

In order to classify the microcapsules having small and uniform diameters, the microcapsules can be subjected to classification in accordance with the centrifugal separation. As the classification method for the microcapsule with centrifuge separation, a method described in JP-A No. 2005-96124 is effective.

There is not any particular restriction with the method for measuring the diameter of the microcapsule, it is appropriately selected depending on the intended purpose, and for example, a particle diameter measuring device, a laser diffractive particle diameter distribution measuring device, a scanning electron microscope (SEM), etc., are available.

There is not any particular restriction for the shell material of the microcapsule mentioned above, and it is appropriately selected depending on the intended purpose, provided that it is opaque at room temperature and becomes transparent on heating. Examples thereof include a macromolecular substance, etc. There is not any particular restriction for the macromolecular substance mentioned above, and it is appropriately selected on depending the intended purpose. For example, the macromolecule substance is preferably a macromolecule having a glass transition temperature of 60°C to 200°C, such as polyurethane, polyurea, polyamide, polyester, a urea-formaldehyde resin, melamine resin, polystyrene, a styrene-methacrylate copolymer, a styrene-acrylate copolymer, etc.

There is not any particular restriction for a method for forming a shell capsule of the microcapsule, and it is

appropriately selected from those known in the art. For example, an interfacial polymerization method, an internal polymerization method, etc., are available. The details of the method for forming the microcapsule and concrete examples of the applicable reactant are described for example in U. S. Patent Nos. 3,726,804, 3,796,669, etc. In the case where polyurea and polyurethane are used as the shell material of microcapsule, polyisocyanate and a second substance (for example, polyol or polyamine) that reacts with the polyisocyanate to form a capsule shell of the microcapsule are mixed into an aqueous solvent or oil solvent to be microcapsulized, the mixture is emulsified and dispersed in water followed by heating, and polymerization reaction is induced at an interference of the formed oil droplet, to thereby yield a capsule shell of the microcapsule. Note that, polyurea can be formed without using the aforementioned second substance. Amongst of them, the forming method applying at least either of polyurethane and polyurea is preferred in view of excellent productivity and heat response sensitivity.

-Processing method for the microcapsule-

There is not any particular restriction for a method for forming the microcapsule, and it is appropriately selected depending on the intended purpose. Examples thereof include a method for forming microcapsules encapsulating a diazonium salt therein by surrounding with a polyurea or polyurethane shell wall. In this method, the diazonium salt compound is dissolved or dispersed in a hydrophobic organic solvent so as to form an oil phase which becomes a core of the microcapsule. To the oil phase, polyvalent isocyanate is further added as a wall material of the microcapsule.

The hydrophobic organic solvent for use in the preparation of the oil phase is preferably an organic solvent having a boiling point of 100°C to 300°C. The specific examples thereof include alkylnaphthalene, alkyldiphenylethane, alkyldiphenylmethane, alkylbiphenyl, alkylterphenyl, chlorinated paraffin, esterphosphates, estermaleates, esteradipates, esterphthalates, esterbenzoates, estercarbonates, ethers, estersulfates, and estersulfonates, etc. These can be used in a combination of two or more.

In case where the solubility of the diazonium salt compound to be microcapsulized to the organic solvent is insufficient, a solvent with a low boiling point, to which the diazonium salt compound has a high solubility, can be added. Examples of the solvent with a low boiling point are ethylacetate, propylacetate, isopropylacetate, butylacetate, methylenechloride, tetrahydrofuran, acetonitrile, acetone, etc.

Thus, the diazonium salt compound preferably has an appropriate solubility to the hydrophobic organic solvent with a high boiling point and the organic solvent with a low boiling point. Specifically, the solubility of the diazonium salt compound is preferably 5% or more to the aforementioned solvents, and 1% or less to water.

As a water phase, a solution wherein a water-soluble macromolecule is dissolved is used. The oil phase is added into the water phase, and emulsification and dispersion are performed for example by means of homogenizer. The water-soluble macromolecule enables uniform and easy dispersion, and functions as a dispersant to stabilize the emulsified and dispersed aqueous solution. In order to make the aqueous solution further uniformly emulsified, dispersed, and stabilized, a surfactant can be added in at least one of the oil phase or the water phase, or in both. The surfactant can be selected from any known surfactants for emulsion in the art.

In the case where the surfactant is added, the usage amount of the surfactant is preferably 0.1% by mass to 5% by mass, and more preferably 0.5% by mass to 2% by mass with respect to the total mass of the oil phase.

The aforementioned water-soluble macromolecule is preferably a water-soluble macromolecule having a solubility of 5% or more to water having a temperature at the time of emulsification. Specific examples thereof include polyvinyl alcohol and a modified compound thereof, polyacrylic amide and a derivative thereof, ethylene-vinylacetate copolymer, styrene-maleic anhydride copolymer, ethylene-maleic anhydride copolymer, isobutylene-maleic anhydride copolymer, polyvinylpyrrolidone, ethylene-acrylic acid copolymer, vinyl acetate-acrylic acid copolymer, carboxymethylcellulose, methylcellulose, casein, gelatin, starch derivative, Arabic gum, Sodium alginate, etc.

It is preferred that the aforementioned water-soluble macromolecule has no or low reactivity with an isocyanate compound, e.g. polyvalent isocyanate. In the case of gelatin having one or more reactive amino groups in its molecular chain, such the gelatin is preferably treated by modification or the like in advance, so as to loose the reactivity with the isocyanate compound.

There is not any particular restriction for the aforementioned polyvalent isocyanate, and it is appropriately selected depending on the intended purpose. Preferably, the polyvalent isocyanate is a compound containing three or more functional isocyanate groups, or a compound containing two or more functional isocyanate groups. Specific examples thereof include: as a main component, diisocyanate such as, xylenediisocyanate and a hydrate thereof, hexamethylenediisocyanate, tolylenediisocyanate, i.e., methylphenylenediisocyanate and a hydrate thereof, isophoronediisocyanate, etc.; dimmer or trimer thereof (biuret or isocyanurate); a multi-functional compound, for example, an adduct of polyol, e.g., trimethylolpropane and bi-functional isocyanate, e.g. xylenediisocyanate; a compound wherein a macromolecule compound such as polyether having an active hydrogen such as polyethylene oxide is introduced into the aforementioned multi-functional compound; and a formalin-benzeneisocyanate condensation product.

The compounds described in JP-A Nos. 62-212190, 04-26189, 05-317694, 08-268721, etc., are also preferable.

The applied amount of the polyvalent isocyanate is determined so that the microcapsule has an average diameter of 0.3 μm to 1.2 μm, and a shell thickness of 0.01 μm to 0.3 μm. The dispersed diameter of the polyvalent isocyanate is generally at around 0.2 μm to 10 μm.

In the emulsified dispersion wherein the oil phase is added into the water phase, at the interface of the oil phase and the water phase, the polyvalent isocyanate is polymerized to form polyurea shell wall.

Furthermore, either of polyol and polyamine can be added into either of the water phase and the hydrophobic organic solvent in the oil phase so that the polyol or polyamine is reacted with the polyvalent isocyanate to form the microcapsule wall. During this reaction, it is preferred that a reaction temperature is maintained high or that a polymerization catalyst is added in view of acceleration of the reaction.

Specific examples of the polyol or polyamine include propyleneglycol, glycerin, trimethylolpropane, triethanolamine, sorbitol, hexamethylenediamine, etc. In the case where the polyol is added, polyurethane shell wall is formed.

The polyvalent isocyanate, polyol, catalyst, and polyamine which forms a partial structure of the capsule wall material are described in detail in the following publication ("Polyurethane handbook" by Keiji Iwata, NIKKAN KOGYO SHIMBUN LTD., in 1987).

The emulsification mentioned above is appropriately performed with a means appropriately selected from those known emulsifiers such as homogenizer, Munton-Golin emulsifier, ultrasonic emulsifier, dssolver, and Keddy mill, etc. After emulsified, the emulsion is heated at 30°C to 70°C, to promote the microcapsule shell forming reaction. During this reaction, in order to present the cohesion of the microcapsules, it is necessary to add water so as to lower the collision probability of the microcapsules or to sufficiently stir.

Otherwise, a dispersant as a condensation inhibitor can be additionally added during the aforementioned reaction. The generation of carbondioxide gas can be observed as the polymerization reaction is proceeded, and the termination of the microcapsule shell forming reaction can be confirmed with the termination of the gas generation. Generally, with the several-hour reaction, the predetermined microcapsules each encapsulating the diazonium salt compound can be attained.

-Diazonium salt compound-

There is not any particular restriction for the diazonium salt compound mentioned above, and it is appropriately selected depending on the indented purpose. The diazonium salt compound is, for example, a diazonium salt containing at least one substituent that is an electron donating group having a negative value of Hammett $\sigma_p$.

Specific examples of the diazonium salt compound include a compound expressed by the following General Formula I, and the like:

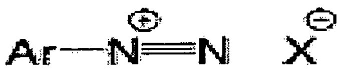

General Formula I

In General Formula I, Ar denotes an aromatic ring, and $X^-$ denotes a counter anion.

The aromatic ring Ar optionally has a substituent Y, the Y is preferably an electron donating group or electron accepting group. In the case where the Ar has two or more the substituents Y, all of the substituents Y may be the same or different.

There is not any particular restriction for the substituent Y in the Ar mentioned above, and it is appropriately selected depending on the intended purpose. Examples of the substituent Y include a substituted amino group, an alkylthio group, an arylthio group, an alkoxy group, an aryloxy group, etc.

In case the substituent Y is the substituted amino group, it is preferred that the substituted amino group is selected from C1-20 alkylamino groups, C2-20 dialkylamino groups, C6-10 arylamino groups, C7-20 N-alkyl-N-arylamino groups, and C2-20 acylamino groups. Optionally, these substituents further have at least one substituent. Moreover, the two or more substituents such as the alkyl groups may be bonded each other to form a cyclic amino group.

In case the substituent Y is the alkylthio group, it is preferred that the alkylthio group is selected from C1-18 alkylthio groups. In case the substituent Y is the arylthio group, it is preferred that the arylthio group is selected from C6-10 arylthio groups. In case the substituent Y is the alkoxy group, it is preferred that the alkoxy group is selected from C1-18 alkoxy groups. In case the substituent Y is the aryloxy group, it is preferred that the aryloxy group is selected from C6-10 aryloxy groups. Optionally, these substituents further have at least one substituent.

Specific examples of the substituent Y of the substituted amino group, the alkylthio group, the arylthio group, the alkoxy group, and alkyl group and aryl group in aryloxy group, are as follows, etc.:

$-CH_3$ $-C_2H_5$ $-C_3H_7$ $-C_4H_9$ $-C_5H_{11}$

$-C_6H_{13}$ $-C_8H_{17}$ $-C_9H_{19}$ $-C_{10}H_{21}$

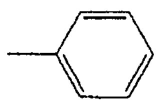 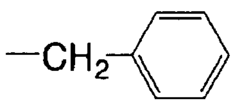 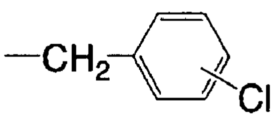 $-C_2H_4-OCH_3$

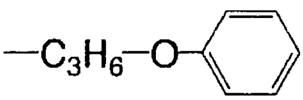 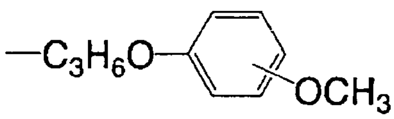 $-C_2H_4-Cl$

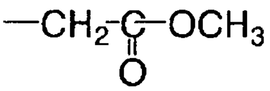 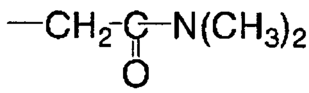 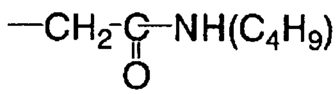

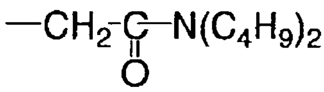 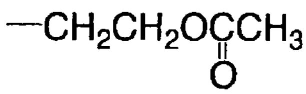 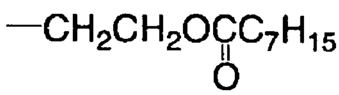

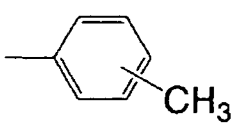 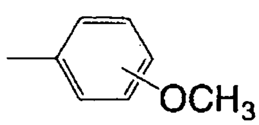 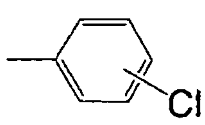 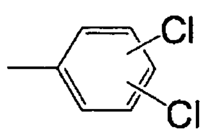

Furthermore, other specific examples of the substituent Y are a hydrogen atom, a C1-8 alkyl group, a chlorine atom, a fluorine atom, a C1-15 alkoxy group, a C1-12 alkylsulfonyl group, a C6-18 arylsulfonyl group, a C1-18 acyl group, a C1-18 alkoxycarbonyl group, a C1-12 sulfonamide group, a C2-13 carbonamide group, a nitro group, and a cyano group.

Each of the aforementioned alkyl group and alkylsulfonyl group is optionally branched, or substituted with a halogen atom, an alkoxy group, an aryloxy group, a phenyl group, an alkoxycarbonyl group, an acyloxy group and a carbamoyl group.

The arylsulfonyl group may be further substituted with a halogen atom, an alkyl group, and an alkoxy group.

Examples of other substituent Y are substituesnts presented as follows:

$-CH_3$ $-C_2H_5$ $-C_3H_7$ $-C_4H_9$ $-C_6H_{13}$ $-C_8H_{17}$

$-SO_2CH_3$ $-SO_2C_4H_9$ $-SO_2C_8H_{17}$ $-SO_2C_{12}H_{25}$ $-SO_2C_{18}H_{37}$

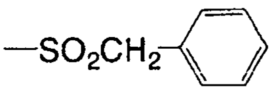 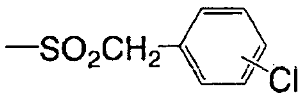 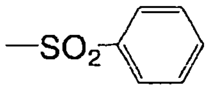

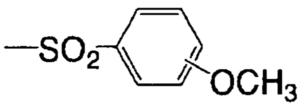 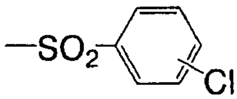 $-COCH_3$ $-COC_2H_5$

$-COC_7H_{15}$ 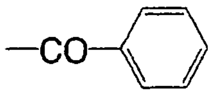 $-CO_2CH_3$ $-CO_2C_4H_9$

$-CO_2C_8H_{17}$ $-CO_2C_{12}H_{25}$ $-NO_2$ $-CN$ $-Cl$ $-F$

$-SO_2NHC_4H_9$ $-SO_2N(C_4H_9)_2$ 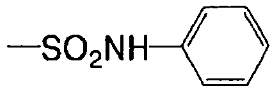

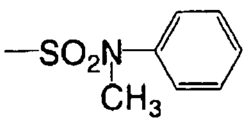 $-CONHC_6H_{13}$ $-CON(C_2H_5)_2$

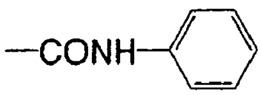 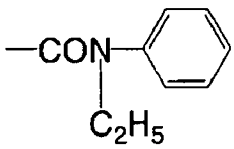 .

In case the substituent Y is the aforementioned substituted amino group, examples of the cyclic amino group formed as a result of bonding between two or more such substituents are as follows:

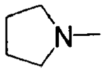 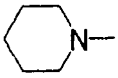 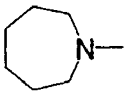 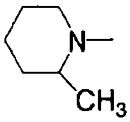 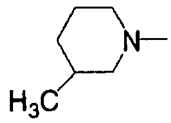

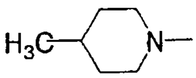 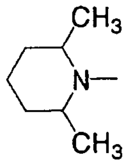 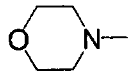 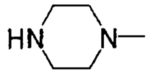

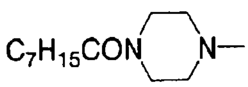 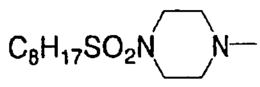 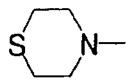

In General Formula I, the counter anion $X^-$ is selected from, for example, C1-20 perfluoroalkylcarbonic acids such as perfluorooctanoic acids, perfluorodecanoic acids, and perfluorododecanoic acids; C1-20 perfluoroalkylsulfonic acids such as perfluorooctanesulfonic acids, perfluorodecansulfonic acids, and perfluorohexadecansulfonic acids; C7-50 aromatic acids such as 4,4-di-t-butylsalicylic acid, 4-t-octyloxybenzoic acid, 2-n-octyloxybenzoic acid, 4-t-hexadecylbenzoic acid, 2,4-bis-n-octadecyloxybenzoic acid, and 4-n-decylnaphthoic acid; C6-50 aromatic sulfonic acids such as 1,5-naphthalenedisulfonic acids, 4-t-octyloxybenzensulfonic acids, and 4-n-dodecylbenzensulfonic acids; 4,5-di-t-butyl-2-naphthoic acids; tetrafluoroboric acids; tetraphenylboric acids; hexafluorophosphoric acid; and the like. Amongst of them, C6-16 perfluoroalkylcarbonic acids, C10-40 aromatic acids, C10-40 aromatic sulfonic acids, tetrafluoroboric acids, tetraphenylboric acids, and hexafluorophosphoric acids are preferred.

Specific examples of the diazonium salt compound include following Compounds 1-36, but the diazonium salt compound for use in the present invention is not necessarily limited thereto:

[Compound 1]

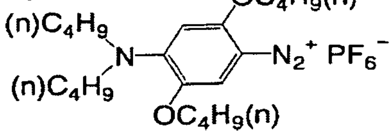

[Compound 2]

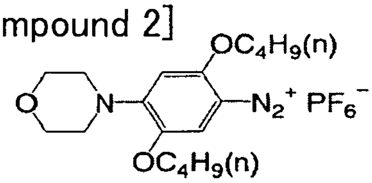

[Compound 3]

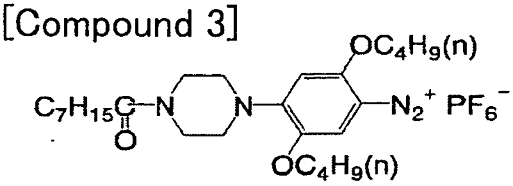

[Compound 4]

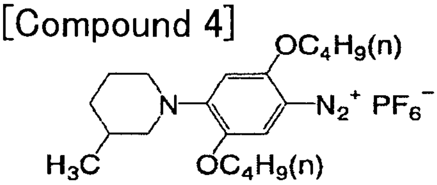

[Compound 5]

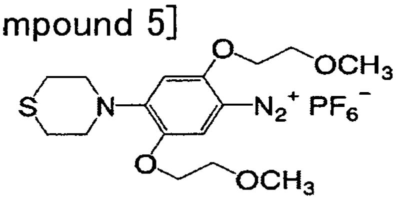

[Compound 6]

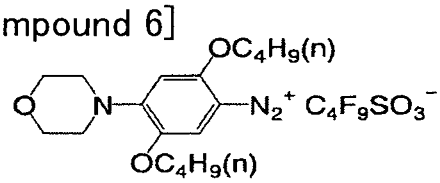

[Compound 7]

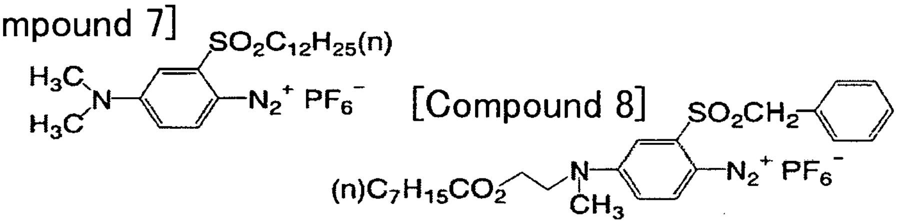

[Compound 8]

[Compound 9]

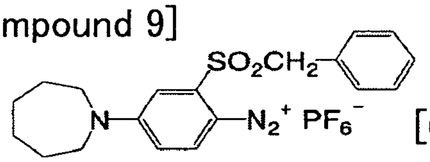

[Compound 10]

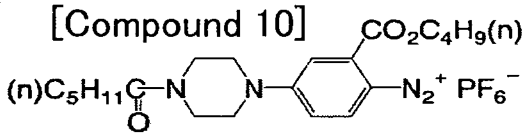

[Compound 11]

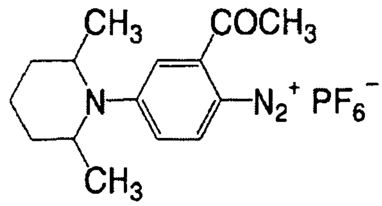

[Compound 12]

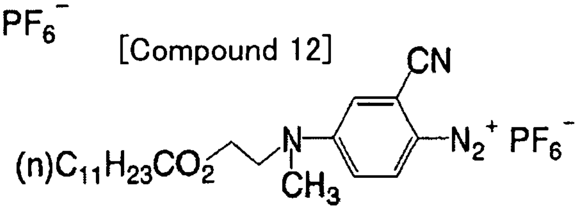

[Compound 13]

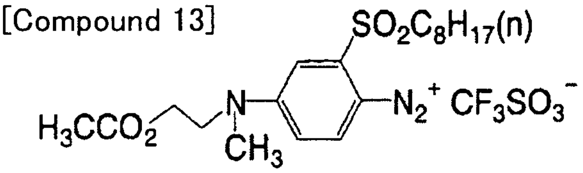

[Compound 14]

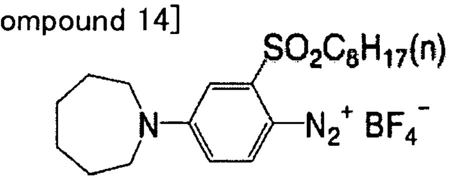

[Compound 15]

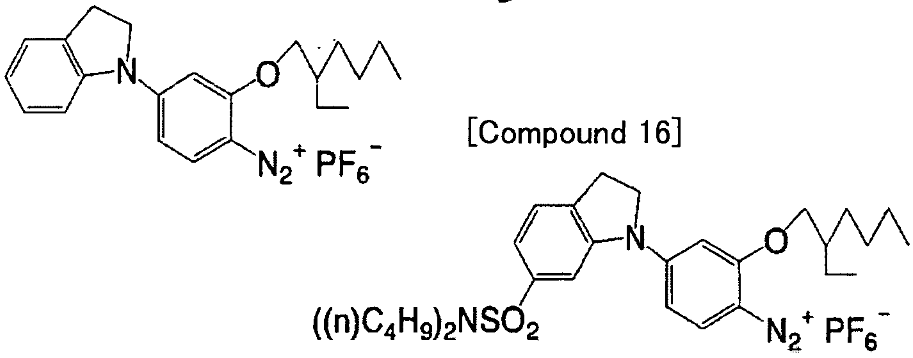

[Compound 16]

[Compound 17]

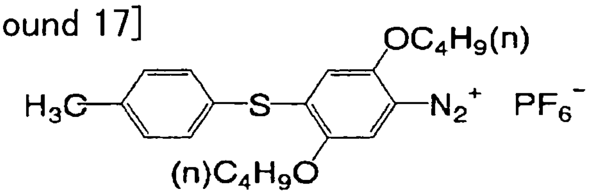

[Compound 18]

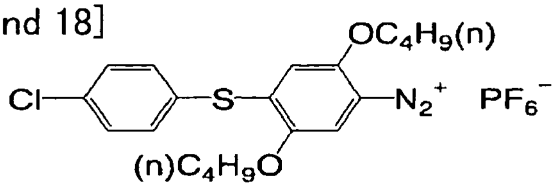

[Compound 19]

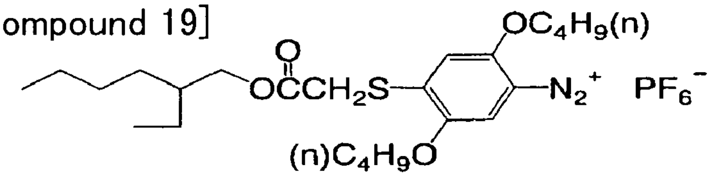

[Compound 20]

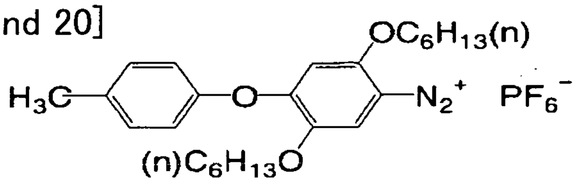

[Compound 21]

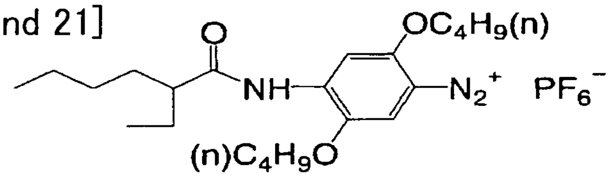

[Compound 22]

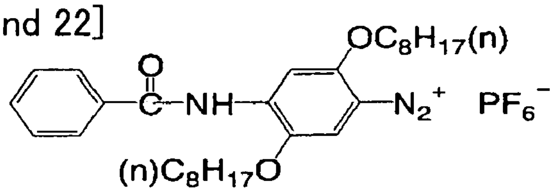

[Compound 23]

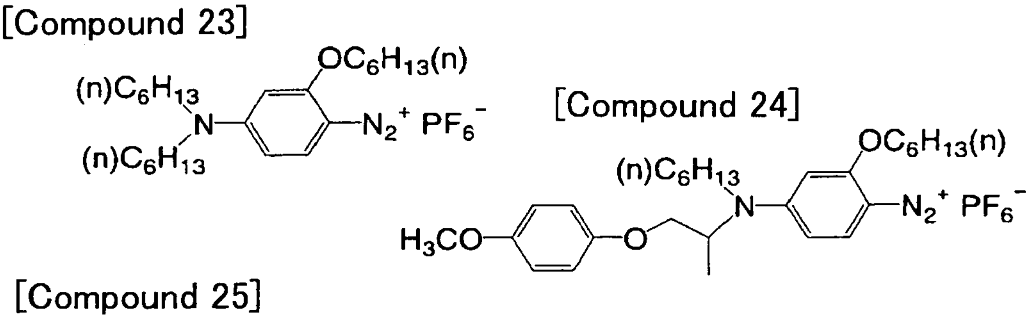

[Compound 24]

[Compound 25]

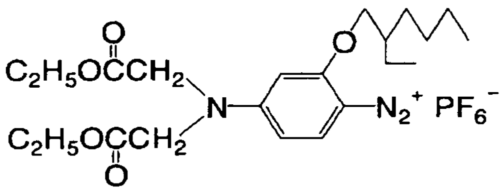

[Compound 26]

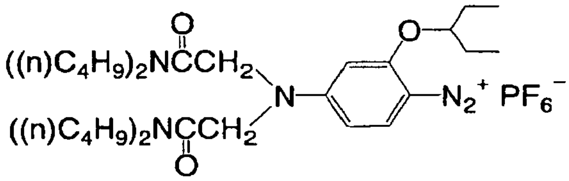

[Compound 27]

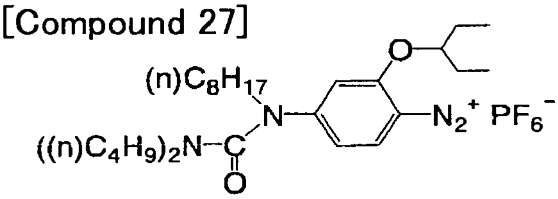

[Compound 28]

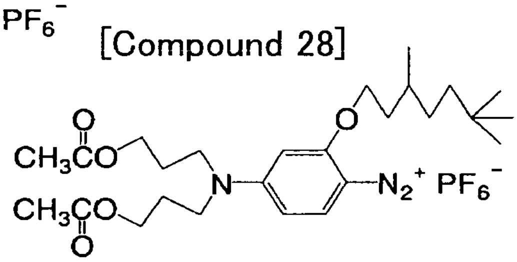

[Compound 29]

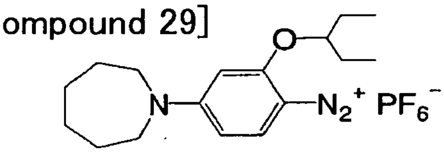

[Compound 30] 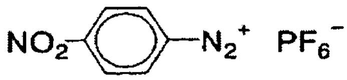

[Compound 31] 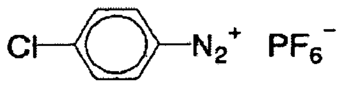

[Compound 32] 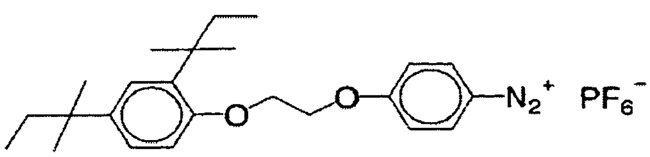

[Compound 33]

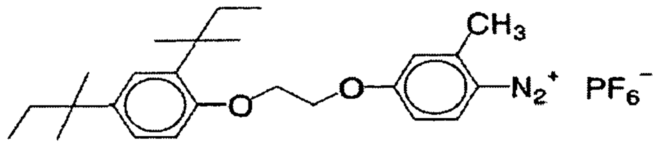

[Compound 34]

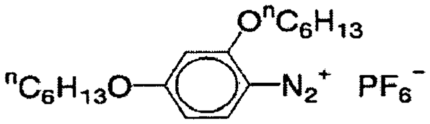

[Compound 35]

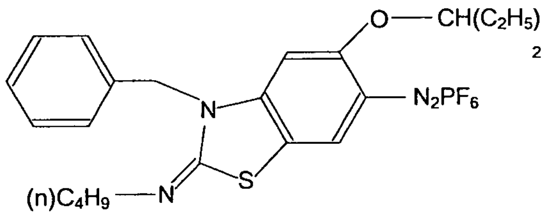

[Compound 36]

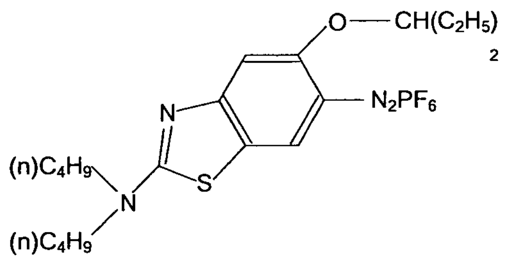

There is not any particular restriction for the content of the diazonium salt compound in the recording layer, and it is appropriately selected depending on the intended purpose. For example, it is preferably 0.05 mmol/$m^2$ to 10 mmol/$m^2$, and more preferably 0.1 mmol/$m^2$ to 3 mmol/$m^2$.

Moreover, it is preferred that the diazonium salt compound with a maximum absorption wavelength of 330 nm to 1,000 nm.

-Binder resin-

The binder resin is used in the recording layer for the purpose of improving film formability, film strength, and recordability of hologram, and is appropriately in view of the compatibility with other components in the recording layer. There is not any particular restriction for the binder resin mentioned above, and it is appropriately selected from the ones known in the art, depending on the intended purpose. Examples of the binder resin include: a polyvinylalcohol resin; gelatin; vinylchloride-vinylacetate copolymer; copolymer of vinylchloride and/ or vinyl acetate and at least one selected from vinyl alcohol, maleic acid, and acrylic acid; vinylchloride-vinilidenechloride copolymer; vinylchloride-acrylonitrile copolymer; ethylene-vinylacetate copolymer; cellulose derivatives such as a nitrocellulose resin; polyacrylic resin; polyvinylacetal resin; polyvinylbutyral resin; epoxy resin; phenoxy resin; polyurethane resin; polycarbonate resin; novolak resin; soluble nylon; polystyrene resin; melamine resin; formalin resin; and the like. These may be used singly or in combination of two or more.

To further improve the dispersivity and durability, a polar group(s) is preferably introduced into molecules of the aforementioned binder resin. Examples of the polar group are an epoxy group, $-CO_2H$, -OH, $-NH_2$, $-SO_3M$, $-OSO_3M$, $-PO_3M_2$, $-OPO_3M_2$, and the like, provided that M is at least any one of a hydrogen atom, an alkali metal, and ammonium. Moreover, in case more than one M are present in the one polar group, such M may be mutually different. The content of the polar group is preferably $10^{-6}$ equivalence to $10^{-4}$ equivalence per one gram of the binder resin.

The aforementioned binder resins can be added with a crosslinking agent selected from the ones known in the art, e.g., hemiacetal and isocyanate, so as to proceed with curing.

There is not any particular restriction for the content of the binder resin in the total solids content of the recording layer, and it is appropriately selected depending on the intended purpose. For example, it is preferably 10% by mass to 95% by mass, and more preferably 35% by mass to 90% by mass. In the case where the content is less than 10% by mass, the stable interference image might not be obtained. In the case where the content is more than 95% by mass, on the other hand, the desirable performance might not be obtained in terms of the diffraction efficiency.

The binder content of the recording layer is preferably 10% by mass to 95% by mass, and more preferably 35% by mass to 90% by mass with respect to the total solids content of the recording layer.

The recording layer can be formed in accordance with a wet film forming method, for example in a manner such that materials for the recording layer are dissolved and/or dispersed in a solvent to form a coating solution, and the coating solution is then applied and dried. There is not any particular restriction for the wet film forming method, it is appropriately selected from the known methods in the art, depending on the intended purpose. Examples of such the method include an ink jet method, a spin coating method, a kneader coating method, a bar coating method, a blade coating method, a casting method, a dipping method, and a curtain coating method.

There is not any particular restriction for the thickness of the recording layer, and it is appropriately selected depending on the intended purpose. It is preferably 1 μm to 1,000 μm, and more preferably 100 μm to 700 μm.

In the case where the thickness of the recording layer is within the aforementioned preferred numerical range, the sufficient S/N ratio can be attained on the shift multiplex of 10 to 300. In the case where the thickness is within the aforementioned more preferred range, such the technical effect becomes significant.

<Other layers>

There is not any particular restriction for the other layers for use in the optical recording medium of the invention, and it is appropriately selected depending on the intended purpose. For example, the optical information recording medium contains a substrate, and optionally contains a gas barrier layer, a reflection protecting layer, a protective layer, or the like.

-Substrate-

There is not any particular restriction for the substrate with its shape, structure, and the size, etc., and it is appropriately selected depending on the intended purpose. For example, with the shape, disk shape, card shape, flat plate shape, and film sheet shape, etc., are available, with the structure, both a single-layered structure and a multi-layered structure are available, and with the size, it is appropriately selected depending on the size of the optical recording medium.

There is not any particular restriction for a material of the substrate, and both a inorganic material and an organic material are appropriately available. However, the material of the substrate needs to be the one which ensures the mechanical strength of the optical recording medium. Moreover, in the case where the optical recording medium is of a transparent type in which light for recording and reproducing passes through the substrate, the substrate has a sufficient transparency at the wavelength range of the applied light.

Examples of the inorganic material include glass, quartz glass, silicon, etc.

Examples of the organic material include: acetate resins such as triacetylcellulose; polyester resins; polyethersulfone resins; polysulfone resins; polycarbonate resins; polyamide resins; polyimide resins; polyolefin resins; acrylic resins; polynorbornene resins; cellulose resins; polyarylate resins; polystyrene resins; polyvinylalcohol resins; polyvinylchloride resins; polyvinilidenechloride resins; polyacrylic resins; polylactate resins; plastic film laminated paper; and synthesized paper. They may be used singly or in combination of two or more. Amongst of them, the polycarbonate resins and the acrylic resins are preferable in view of the formability, the optical property, and the cost performance.

The aforementioned substrate can be selected from the appropriately synthesized materials and the commercially available products.

There is not any particular restriction with the thickness of the substrate, and it is appropriately selected depending on the intended purpose. It is preferably 0.1 mm to 5 mm, and more preferably 0.3 mm to 2 mm. In the case where the thickness of the substrate is less than 0.1 mm, the disk (optical recording medium) can not bear the shape distortion during storing. In the case the thickness is more than 5 mm, the weight of the disk (the optical recording medium) becomes heavy, and excessive lords might be applied to means such as a driving motor when the disk is rotated by means of the driving motor.

-Gas barrier layer-

There is not any particular restriction for the substrate with its shape, structure, and the size, etc., and it is appropriately selected depending on the intended purpose.

The gas barrier layer preferably has the oxygen permeability coefficient of 0.1ml·25μm/$m^2$·24h ·atm or less under the condition of a temperature at 23°C and a relative humidity at 50%. In the case where the oxygen permeability coefficient of the gas barrier layer is controlled at 0.1ml·25μm/$m^2$·24h ·atm or less under the condition of a temperature at 23°C and a relative moisture at 50%, the diameters of the generated gas bubbles can preferably be controlled to be 0.4 μm or less.

<Optical recording method>

There is not any particular restriction for the optical recording method mentioned above, and it is appropriately selected depending on the intended purpose. For example, a transmission method and a reflective method, etc., are available. The recording method for hologram is not particularly limited, and any one of amplitude hologram, phase hologram, blazed hologram, multi-element amplitude hologram, etc. can be applied. For example, the optical recording method is the reflective optical recording method as shown in FIG. 1. In the optical recording method, light irradiated from the light source 61 is split into two, information light 51 and reference light 52, by the half mirror 64. The light which transmit through the half mirror 64 is the information light 51, and the light which is reflected by the half mirror 64 is the reference light 52. The information light 51 is expanded, and irradiated onto the recording layer of the optical recording medium 50, via a mirror 66 and a beam expander 68, and the reference light 52 is expanded, and irradiated onto the opposite surface of the recording layer where the information light 51 is irradiated, via a mirror 65 and a beam expander 67. When the information light 51 and the reference light 52 are irradiated in this manner, the information light 51 and the reference light 52 are interfered within the recording layer, the interference fringes are formed thereby, and such the interference fringes are recorded. In FIG. 1, 62 denotes a light source, 52 denotes sensitization light, and 69 denotes a beam expander. Note that the interference fringes are an interference image which corresponds to the optical information.

-Fixing of the interference image-

The interference image mentioned above can be fixed onto the recording layer. The fixing means herein that, after the recording of the interference image is performed, the gas generating substance remained in the recording layer is uniformly and completely decomposed by radiation of light. If the gas generating substance is remained in the recording layer after the completion of the recording, such the gas generating substance is partially decomposed by light for reproducing at the time of reproducing, and thus the recorded image is obscured thereby. In order to prevent this problem, it is preferred that the remained gas generating substance is completely decomposed by the fixing before reproducing is carried out.

The fixing mentioned above is preferred to be performed by controlling an energy of exposure light per area so that the generated gas as a result of the decomposition of the gas generating substance does not form a hologram which disturb the already recorded interference image. Thus, the light source for the fixing is preferably a light source with an extremely week energy intensity compared to that of the light source for recording and reproducing. Examples of such the light source include a light source capable of emit incoherent light.

Coherence is one of the properties of waves, that indicates, the degree of interference (clarity of the interference fringe contrast). In the case where two single-color waves of lights have a mutually equal frequency, the degree of interference thereof becomes maximum. In this way, the condition with maximum interference degree is called coherence, and on the other hand, the condition with no interference is called incoherence.

In reality, there is no light which is absolutely coherent, but a laser beam is temporally and specially very highly coherent. Thus, it is often represented as being coherent. On the other hand, a sunlight or a light emitted from an electric lamp or a fluorescent lamp has a very low coherence, and is almost incoherent. These lights are therefore often represented as being incoherent. The condition in between the coherence and incoherence is represented as a partial coherence. The waveform of the light that is not coherent has a spectrum, which is the Fourier transformed amplitude, with a certain width. The laser beam, which is generally recognized as a coherent light, has a spectrum of narrow width, but it is not narrow enough to be ignored. Note that, in the case the spectrum width can be ignored depending on the purpose, such the light can be represented as coherence. On the other hand, a white light is represented as incoherence, as the white light has the mixture of many lights having mutually different frequencies.

In the present invention, examples of the coherent light include laser beams, and examples of the incoherent light include lights emitted from a fluorescent lamp, a high tension mercury lamp, a halogen lamp, a xenon lamp, a LED, and the like. Moreover, the laser beam, which is originally coherent, can be treated to be incoherent in a manner such that the laser beam is emitted to an optical recording medium in accordance with a method wherein a phase and/or

frequency thereof is made varied.

The energy intensity of the incoherent beam (it might be referred to "radiation power" hereinafter) is preferred less than 100 $mJ/cm^2$, and more preferably at less than 75 $mJ/cm^2$.

There is not any particular restriction for the radiation method, and it is appropriately selected depending on the intended purpose. The radiation is performed, for example, on the entire surface, in the form of lines, or in the form of dots.

<Optical information reproducing method>

There is not any particular restriction for the optical information reproducing method, and it is appropriately selected depending on the intended purpose. Examples thereof include a method wherein an optical recording medium recorded in accordance with the optical recording method of the present invention is irradiated with the identical light to the reference light at the time of the recording from the identical direction. When the light is irradiated to the interference image formed in the recording layer of the optical recording medium, the light is diffracted corresponding to the interference image, the recorded information is reproduced by receiving the diffracted light as a recording information.

<<Second embodiment>>

The second embodiment of the optical recording medium is applied for collinear hologram recording method wherein information light and reference light are irradiated in such the manner that the optical axis of the information light and the optical axis of the reference light become collinear. The second embodiment of the optical recording medium contains a first substrate, a second substrate, a recording layer disposed between the first substrate and the second substrate, a filter layer disposed between the second substrate and the recording layer.

<Optical information recording and reproducing method in second embodiment>

The optical recording method in the second embodiment is an optical recording method, what is called a collinear method, which contains: irradiating an information light and a reference light as a co-axial luminous flux to the optical recording medium so as to form and record an interference pattern on the recording layer of the optical recording medium.

There is not any particular restriction for the optical information reproducing method, and it is appropriately selected depending on the intended purpose. For example, the recorded information is reproduced by irradiating a light identical to the reference light to the interference image formed in the recording layer in accordance with the optical recording method of the present invention.

In the optical information recording and reproducing method in the second embodiment mentioned above, information light with the two-dimensional intensity distribution and reference light with almost the same light intensity to that of the information light are superimposed inside the photosensitive recording layer, the resulted interference pattern formed inside the recording layer induces a distribution of the optical properties of the recording layer to thereby record such the distribution as an information. When the recorded information is read (reproduced), only reference light is irradiated to the recording layer from the same direction to that irradiated at the time of recording, a light having a intensity distribution corresponding to the distribution of the optical property formed inside the recording layer is emitted from the recording layer as a reproducing light.

The optical information recording and reproducing method for the second embodiment is performed, for example, by means of an optical information recording and reproducing apparatus explained hereinafter.

The optical information recording and reproducing apparatus applied in the aforementioned optical information recording and reproducing method is explained with reference to FIG. 12.

FIG. 12 is a block flowchart showing the whole mechanism of the optical information recording and reproducing apparatus for use in the second embodiment. Note that, the optical information recording and reproducing apparatus contains both of the optical recording apparatus and the optical information reproducing apparatus.

This optical information recording and reproducing apparatus 100 is equipped with a spindle 81 on which an optical recording medium is deposed 20, a spindle motor 82 which rotates the spindle 81, and a spindle servo circuit 83 which controls the spindle motor 82 so as to maintain the optical recording medium 20 at the predetermined revolution number.

The optical information recording and reproducing apparatus 100 is also equipped with a pickup unit 31 which irradiates an information light and a reference light to the optical recording medium so as to record an information, and irradiates a reference light for reproducing to the optical recording medium 20 so as to detect a reproducing light to thereby reproduce the recorded information, and a driving unit 84 which enables the pickup unit 31 to move in the radius direction of optical recording medium 20.

The optical information recording and reproducing apparatus 100 is equipped with a detecting circuit 85 which

detects focusing error signal FE, tracking error signal TE, and reproducing signal RF from the output signal of the pickup unit 31, a focusing servo circuit 86 which drives an actuator in the pickup unit 31 so as to move an objective lens (not shown in FIG. 12) to the radium direction of the optical recording medium 20 based upon the focusing error signal FE detected by the detecting circuit 85 to thereby perform focusing servo, a tracking servo circuit 87 which drives an actuator in the pickup unit 31 so as to move an objective lens (not shown in FIG. 12) to the radium direction of the optical recording medium 20 based upon the tracking error signal TE detected by the detecting circuit 85 to thereby perform tracking servo, and a sliding servo unit 88 which controls the driving unit 84 based upon the tracking error signal TE and an indication from a controller mentioned hereinafter so as to move the pickup unit 31 to the radius direction of the optical recording medium 20 to thereby perform sliding servo.

Moreover, the optical information recording and reproducing apparatus 100 is equipped with a signal processing circuit 89 which decodes output data of the later described CMOS or CCD array in the pickup unit 31, to thereby reproduce the data recorded in the data area of the optical recording medium 20, and reproduces the standard clock or determines the address based on the reproducing signal RF from the detecting circuit 85, a controller 90 which controls the whole optical information recording and reproducing apparatus 100, and a controlling unit 91 which gives various instructions.

The controller 90 is configured to input the standard clock or address information outputted from the signal processing circuit 89 as well as controlling the pickup unit 31, the spindle servo circuit 83, the slid servo circuit 88, and the like. The spindle servo circuit 83 is configured to input the standard clock outputted from the signal processing circuit 89. The controller 90 contains CPU (center processing unit), ROM (read only memory), and RAM (random access memory), the CPU realizes the function of the controller 90 by executing programs stored in the ROM on the RAM, a working area.

The optical information recording and reproducing apparatus applied for the optical information recording and reproducing method in the second embodiment uses the optical information medium of the present invention, and applies sensitization light to the optical information recording medium so as to induce photothermal conversion to thereby sensitize, at the same time to the recording of interference fringes by information light and reference light. Therefore, there can be provided an optical recording medium having high resolution and high diffraction efficiency.

<Recording layer>

As the recording layer, the same recording layer mentioned in the first embodiment can be applied.

<Filter layer>

The filter layer serves to eliminate the occurrence fluctuations in the wavelengths selected to be reflected in a case where the incident angle is changed, and has a function to prevent irregular reflection of the information light and reference light at the reflective film of an optical recording medium to thereby prevent the occurrence of noise. By providing the filter layer therein, the optical recording medium attains high resolution and diffraction efficiency.

The filter layer is preferably configured to allow a light of a first wavelength pass through and reflect a light of a second wavelength. The first wavelength is preferably 350 nm to 600 nm, and the second wavelength is preferably 600 nm to 900 nm. To this end, the optical recording medium preferably has a layer structure such that the recording layer, the filter layer, and servo-pit patterns are disposed in this order from the side where the optical system is set.

The filter layer has a transmittance of 50% or more, and preferably 80% or more with respect to an incident light of 655 nm with an incident angle of ±40°. The filter layer has a transmittance of 30% or more, and preferably 40% or more with respect to an incident light of 532 nm with an incident angle of ±40°.

There is not any particular restriction for the filter layer, and it is appropriately selected depending on the intended purpose. For example, the filter layer is a laminate of an dielectric material-deposited layer, a single-layered or multilayred cholesteric liquid crystal layer, and other layer selected, if necessary. The filter layer optionally contains a colored material-containing layer.

The filter layer can be directly amounted on the substrate together with recording layer by coating or the like. Alternatively, the filter layer can be prepared on a support such as a film at first, and then dispose the prepared filter layer on the substrate.

-Dielectric material-deposited layer-

The dielectric material-deposited layer is a laminate of two or more dielectric thin layers having different refraction indices. For the dielectric material-deposited layer to serve as a reflective film through which light of desired wavelength passes, it is preferably a laminate of alternating dielectric thin layers with high and low indices of refraction, however, three or more different dielectric thin layers may be laminated.

The number of the dielectric thin layers to be laminated is preferably 2 to 20, more preferably 2 to 12, still further

preferably 4 to 10, and most preferably 6 to 8. If the number of the dielectric thin layers to be laminated is greater than 20, it results in the reduction in productivity because of multilayer vapor deposition. The object and effect of the present invention cannot be achieved in some cases.

The order in which the dielectric thin layers are laminated is not particularly limited, and can be appropriately determined depending on the intended purpose. A dielectric thin layer with lower refractive index is deposited first in a case where the adjacent dielectric thin layer has high refractive index. On the other hand, a dielectric thin layer with higher refractive index is deposited first in a case where the adjacent dielectric thin layer has low refractive index. The criteria of refractive index for determining whether a dielectric thin layer has high or low refractive index is preferably set to 1.8. Note, however, that this determination is made on an arbitrary basis. That is, dielectric thin layers with different refractive indices equal to or greater than 1.8 (i.e., there are dielectric thin layers with high and low refractive indices) may be used to form such a laminate.

The material for the dielectric thin layer with high refractive index is not particularly limited and can be appropriately selected depending on the intended purpose. Examples thereof include $Sb_2O_3$, $Sb_2S_3$, $Bi_2O_3$, $CeO_2$, $CeF_3$, $HfO_2$, $La_2O_3$, $Nd_2O_3$, $Pr_6O_{11}$, $Sc_2O_3$, SiO, $Ta_2O_5$, $TiO_2$ TlCl, $Y_2O_3$, ZnSe, ZnS and Zr02. Among these, $Bi_2O_3$, $CeO_2$, $CeF_3$, $HfO_2$ SiO, $Ta_2O_5$, $TiO_2$ $Y_2O_3$, ZnSe, ZnS and $ZrO_2$ are preferable, and SiO, $Ta_2O_5$, $TiO_2$, $Y_2O_3$, ZnSe, ZnS and $ZrO_2$ are more preferable.

The material for the dielectric thin layer with low refractive index is not particularly limited and can be appropriately selected depending on the intended purpose. Examples thereof include $Al_2O_3$, $BiF_3$, $CaF_{24}$ $LaF_3$, $PbCl_2$, $PbF_2$, LiF, $MgF_2$, MgO, $NdF_3$, $SiO_2$, $Si_2O_3$, NaF, $ThO_2$ and $ThF_4$. Among these, $Al_2O_3$, $BiF_3$, $CaF_2$, $MgF_2$, MgO, $SiO_2$ and $Si_2O_3$ are preferable, and $Al_2O_3$, $CaF_2$, $MgF_2$, MgO, $SiO_2$ and $Si_2O_3$ are more preferable.

Note that the atomic ratio in the material for the dielectric thin layer is not particularly limited and can be appropriately set depending on the intended purpose. The atomic ratio can be adjusted by changing the concentration of atmospheric gas upon deposition of dielectric thin layers.

The method for depositing the dielectric thin layer is not particularly limited and can be appropriately selected depending on the intended purpose. For example, a vacuum vapor deposition process such as ion plating and ion beam, a physical vapor deposition (PVD) such as sputtering, and a chemical vapor deposition (CVD) can be used. Among these methods, a vacuum vapor deposition and sputtering are preferable, and sputtering is most preferable.

For the sputtering, DC sputtering is preferable because it offers high deposition rate. Note that highly conductive material is preferably used when DC sputtering is employed.

Examples of the method for depositing multiple dielectric thin layers by sputtering include a single-chamber method, where multiple dielectric thin layers are alternately or sequentially deposited using a single chamber, and a multi-chamber method, where multiple dielectric thin layers are sequentially deposited using multiple chambers. In view of the productivity and to prevent contamination among materials, the multi-chamber method is most preferable.

The thickness of the dielectric thin layer is preferably λ/16 to λ, more preferably λ/8 to 3λ/4, most preferably λ/6 to 3λ/8 in terms of optical wavelength.

-Cholesteric liquid crystal layer-

The cholesteric liquid crystal layer contains at least a cholesterol derivative or nematic liquid crystal compound, and a chiral compound, and further contains polymerizable mononers, and other components on as-needed basis.

The cholesteric liquid crystal layer may be either a single-layered cholesteric liquid crystal layer or a multilayered cholesteric liquid crystal layer.

The cholesteric liquid crystal layer preferably has a circularly polarizing function. The cholesteric liquid crystal layer selectively reflects light components which have been circularly polarized in the direction in which the liquid crystal helix rotates (i.e., to the right or left) and which have a wavelength that equals to the pitch of the liquid crystal helix. The cholesteric liquid crystal layer utilizes the selective reflection characteristics to separate a particular circularly polarized component of a particular wavelength from natural light of different wavelengths, and reflects the other light components.

The filter layer for optical recording medium preferably has an optical transmittance of 40% or more for light of a wavelength range of $\lambda_0$ to $\lambda_0$/cos20° (where $\lambda_0$ represents the wavelength of irradiation light) incident at an angle of ± 20° (measured from the normal of the surface of the recording layer). Most preferably, the filter layer for the optical recording medium has an optical transmittance of 40% or more for light of a wavelength range of $\lambda_0$ to $\lambda_0$/cos40° (where $\lambda_0$ represents the wavelength of irradiation light) incident at an angle of ±40° (measured from the normal of the surface of the recording layer). If the optical reflectivity is 40% or more for light of a wavelength range of $\lambda_0$ to $\lambda_0$/cos20°, especially $\lambda_0$ to $\lambda_0$/cos40° (where $\lambda_0$ represents the wavelength of irradiation light), it is made possible to eliminate the dependency of reflectivity on incident angle and to adopt optical lens system that is used for general optical information recording media. Therefore, it is preferred that the cholesteric liquid crystal layer has a wide selectively-reflecting wavelength range.

Specifically, in the case of (1) single-layered cholesteric liquid crystal layer, the selectively-reflecting wavelength range Δλ is expressed by the following Equation (1), and liquid crystals having a large value of (ne-no) are suitably used

for the cholesteric liquid crystal layer:

$$\Delta\lambda = 2\lambda(ne - no) / (ne + no) \ldots \text{Equation (1)}$$

where "no" represents the refractive index of the nematic liquid crystal molecules for normal light, contained in the cholesteric liquid crystal layer, "ne" represents the refractive index of the nematic liquid crystal molecules for abnormal light, and $\lambda$ represents the central wavelength of light selectively reflected.

Moreover, as described in JP-A No. 2004-352081, a chiral compound is photosensitive, and is selected from photoreactive chiral compounds whose helical pitch can be largely altered by irradiation with light. By adjusting the content of the photoreactive chiral compound and UV irradiation time, it is possible to provide the filter layer, in which helical pitch is continuously changed in the thickness direction of the liquid crystal layer.

In the case of (2) a multi-layered cholesteric liquid crystal layer, it is preferred that two or more cholesteric liquid crystal layers having the same helical pitches are laminated to the multi-layered cholesteric liquid crystal layer.

There is not any restriction for the cholesteric liquid crystal layer mentioned above provided that at least the above properties are fulfilled, and it is appropriately selected depending on the intended purpose. As described above, the cholesteric liquid crystal layer contains a nematic liquid crystal compound and a chiral compound, and further contains polymerizing monomers and other components, if necessary.

-Nematic liquid crystal compound-

The nematic liquid crystal compound features that their liquid crystal phase solidifies under the liquid crystal transition temperature, and can be appropriately selected from liquid crystal compounds, high-molecular liquid crystal compounds and polymerizable liquid crystal compounds, all of which have refractive index anisotropy $\Delta n$ of 0.10 to 0.40. For example, molecules of such the nematic liquid crystal compound which are in the liquid crystal state by treatment with heat can be aligned by use of a surface-rubbed alignment substrate, followed by a cooling treatment or the like to allow them to be immobilized to the substrate to serve as a solid phase.

The nematic liquid crystal compound is not particularly limited and can be appropriately selected depending on the intended purpose. The nematic liquid crystal compound is preferably a nematic liquid crystal compound having at least one polymerizable group per molecule in view of sufficient curing property. Among such the nematic liquid crystal compounds, ultraviolet (UV) polymerizable liquid crystal compounds are suitably used. Examples of such ultraviolet (UV) polymerizable liquid crystal compounds include the following commercially available products: PALIOCOLOR LC242 (bland name, manufactured by BASF Corp.); E7 (bland name, manufactured by Merck Ltd.); LC-Silicon-CC3767 (bland name, manufactured by Wacker-Chem); and L35, L42, L55, L59, L63, L79 and L83 (bland name, manufactured by Takasago International Corp.).

The content of the nematic liquid crystal compound is preferably 30% by mass to 99% by mass, and more preferably 50% by mass to 99% by mass with respect to the total solids mass of each of the cholesteric liquid crystal layer. If the content of the nematic liquid crystal compound is less than 30% by mass, it may result in poor alignment of nematic liquid crystal molecules.

-Chiral compound-

The chiral compound is not particularly limited and can be appropriately selected from those known in the art; in view of the hues of the liquid crystal compounds and for enhanced color purity. Examples thereof include isomannide compounds, catechine compounds, isosorbide compounds, fenchone compounds and carvone compounds. These chiral compounds may be used singly or in combination of two or more.

In addition, commercially available chiral compounds can also be used, and examples thereof include S101, R811 and CB15 (bland name, manufactured by Merck Ltd.); and PALIOCOLOR LC756 (bland name, manufactured by BASF Corp.).

The content of the chiral compound in each liquid crystal layer of the multilayered cholesteric liquid crystal layer is preferably 0% by mass to 30% by mass, and more preferably 0% by mass to 20% by mass with respect to the total solids mass of each of the liquid crystal layer in the multi-layered cholesteric liquid crystal layer. If the content of the chiral compound is more than 30% by mass, it may result in poor alignment of cholesteric liquid crystal molecules.

-Polymerizing monomer-

It is also possible to add polymerizable monomers to the cholesteric liquid crystal layer in order to, for example,

increase the degree of cure in the layer (e.g., layer strength). Combined use of polymerizable monomers can increase the strength the cholesteric liquid crystal layer, where different twisting degrees have been set for liquid crystals through which light propagates (e.g., the distribution of wavelengths of light to be reflected has been created) and where the helical structure (i.e., selective reflection capability) has been fixed. Note, however, that such polymerizable monomers need not necessarily be added if the liquid crystal compound bears polymerizable groups in a molecule.

The polymerizable monomers are not particularly limited and can be appropriately selected from those known in the art. Examples thereof include monomers bearing ethylenically unsaturated bonds, and specific examples are multifunctional monomers such as pentaerythritoltetraacrylate and dipentaerythritolhexaacrylate. These monomers can be used singly or in combination of two or more.

The content of the polymerizable monomers is preferably 50% by mass or less, and more preferably 1% by mass to 20% by mass with respect to the total solids mass of the cholesteric liquid crystal layer. If the content the polymerizable monomers is more than 50% by mass, it may inhibit the alignment of cholesteric liquid crystal molecules.

-Other components-

The other components are not particularly limited and can be appropriately selected depending on the intended purpose. Examples thereof include photopolymerization initiators, sensitizers, binder resins, polymerization inhibitors, solvents, surfactants, thickeners, dyes, pigments, ultraviolet absorbers and gelling agents.

The photopolymerization initiators are particularly limited and can be appropriately selected from those known in the art. Examples thereof include p-methoxyphenyl-2,4-bis(trichloromethyl)-s-triazine, 2-(p-buthoxystyryl)-5-trichloromethyl-1,3,4-oxadiazole, 9-phenylacridine, 9,10-dimethylbenzphenazine, benzophenone/Michler's ketone, hexaarylbiimidazole/mercaptobenzoimidazole and benzyldimethylketal, thioxanthone/amine. These photoinitiators may be used singly or in combination of two or more.

In addition, commercially available photopolymerization initiators can also be used. Examples thereof include IRGA CURE 907, IRGA CURE 369, IRGA CURE 784 and IRGA CURE 814 (bland name, manufactured by Chiba Specialty Chemicals KK); and Lucirin TPO (bland name, manufactured by BASF Corp.).

The content of the photopolymerization initiator is preferably 0.1% by mass to 20% by mass, and more preferably 0.5% by mass to 5% by mass with respect to the total solids mass of the cholesteric liquid crystal layer. If the content of the photopolymerization initiator is less than 0.1% by mass, it may take long time for the polymerization because of reduced curing efficiency upon irradiation with light. If the content of the photopolymerization initiator is greater than 20% by mass, it may result in poor optical transmittance over the spectrum from ultraviolet to visible light.

The sensitizer is added on an as-needed basis in order to increase the degree of cure in the cholesteric liquid crystal layer.

The sensitizer is not particularly limited and can be appropriately selected from those known in the art. Examples thereof include diethylthioxanthone and isopropylthioxanthone.

The content of the sensitizer is preferably 0.001% by mass to 1% by mass with respect to the total solids mass of the cholesteric liquid crystal layer.

The binder resin is not particularly limited and can be appropriately selected from those known in the art. Examples thereof include: polyvinyl alcohols; polystyrene compounds such as polystyrene and poly-$\alpha$-methylstyrene; cellulose resins such as methylcellulose, ethylcellulose and acetylcellulose; acid cellulose derivatives bearing carboxylic groups on their side chains; acetal resins such as polyvinyl formal and polyvinyl butyral; methacrylic acid copolymers; acrylic acid copolymers; itaconic acid copolymers; crotonic acid copolymers; malleic acid copolymers; partially-esterified malleic acid copolymers; homopolymers of acrylic acid alkylesters or homopolymers of methacrylic acid alkyl esters; and polymers having hydroxyl groups. These binder resins may be used singly or in combination of two or more.

Examples of alkyl groups in the homopolymers of acrylic acid alkylesters or homopolymers of methacrylic acid alkyl esters include a methyl group, an ethyl group, a n-propyl group, a n-butyl group, an iso-butyl group, a n-hexyl group, a cyclohexyl group and a 2-ethylhexyl group.

Examples of the polymers having hydroxyl groups include benzyl(meth)acrylate/(homopolymers of methacrylic acid) acrylic acid copolymers, and multicomponent copolymers of benzyl(meth)acrylate/(meth)acrylic acid/other monomers.

The content of the binder resin is preferably 0% by mass to 80% by mass, and more preferably 0% by mass to 50% by mass with respect to the total solids mass the cholesteric liquid crystal layer. If the content the polymerizable monomers is more than 80% by mass, it may result in poor alignment of cholesteric liquid crystal molecules.

The polymerization inhibitor is not particularly limited and can be appropriately selected depending on the intended purpose. Examples thereof include hydroquinones, hydroquinone monoethylethers, phenothiazines, benzoquinones and derivatives thereof.

The content of the polymerization inhibitor is preferably 10% by mass or less, more preferably 0.01% by mass to 1% by mass relative to the total solids contents of the polymerizable monomers.

The solvent is not particularly limited and can be appropriately selected from those known in the art. Examples thereof include alkoxypropionic acid esters such as 3-methoxypropionic acid methylester, 3-methoxypropionic acid ethylester, 3-methoxypropionic acid propylester, 3-ethoxypropionic acid methylester, 3-ethoxypropionic acid ethylester and 3-ethoxypropionic acid propylester; alkoxy alcohol esters such as 2-methoxypropylacetate, 2-ethoxypropylacetate and 3-methoxybutylacetate; lactic acid esters such as methyl lactate and ethyl lactate; ketones such as methyl ethyl ketone, cyclohexanone and methylcyclohexanone; γ-butyrolactone; N-methylpyrrolidone; dimethylsulfoxide; chloroform; and tetrahydrofuran. These solvents may be used singly or in combination.

The cholesteric liquid crystal layer can be formed in the following procedure: For example, a coating solution for cholesteric liquid crystal layer prepared by use of the solvent is applied on the base material (note that this coating solution is prepared for each liquid crystal layer in the case of a multilayered cholesteric liquid crystal layer). Thereafter, the coating solution is dried, and cured by irradiating it with ultraviolet light.

For mass production, the cholesteric liquid crystal layer can be formed in the following procedure: The base material is previously wound in a roll shape, and the coating solution is then applied on the base material using a long, continuous coater such as a bar coater, die coater, blade coater, or curtain coater.

Examples of the coating method include a spin coating method, casting method, roll coating method, flow coating method, printing method, dip coating method, casting deposition method, bar coating method and gravure printing method.

The UV irradiation condition is not particularly limited and can be appropriately determined depending on the intended purpose; the wavelength of UV light to be applied is preferably 160 nm to 380 nm, more preferably 250 nm to 380 nm; irradiation time is preferably 0.1 second to 600 seconds, more preferably 0.3 second to 300 seconds. By adjusting the UV irradiation condition, it is possible change the helical pitch of the cholesteric liquid crystals continuously in the thickness direction of the liquid crystal layer.

It is also possible to add an ultraviolet absorber to the cholesteric liquid crystal layer in order to adjust the UV irradiation condition. The ultraviolet absorber is not particularly limited and can be appropriately selected depending on the intended purpose; suitable examples thereof include benzophenone ultraviolet absorbers, benzotriazole ultraviolet absorbers, salicylic acid ultraviolet absorbers, cyanoacrylate ultraviolet absorbers and oxalic acid anilide ultraviolet absorbers. Specific examples of these ultraviolet absorbers are disclosed in JP-A Nos. 47-10537, 58-111942, 58-212844, 59-19945, 59-46646, 59-109055 and 63-53544; Japanese Patent Application Publication (JP-B) Nos. 36-10466, 42-26187, 48-30492, 48-31255, 48-41572 and 48-54965, 50-10726; and U.S. Patent Nos. 2,719,086, 3,707,375,3,754,919 and 4,220,711.

In the case of the multilayered colesteric liquid crystal layer, the thickness of each cholesteric liquid crystal layer is preferably 1 μm to 10 μm, and is more preferably 2 μm to 7 μm. If the thickness of the cholesteric liquid crystal layer is less than 1 μm, it results in poor selective reflectivity. If the thickness of the cholesteric liquid crystal layer is more than 10 μm, uniformly aligned liquid crystal molecules in the cholesteric liquid crystal layer may orient in random directions.

The total thickness of the cholesteric liquid crystal layer in a multilayered cholesteric liquid crystal layer (or the thickness of a single-layered liquid crystal layer) is preferably 1 μm to 30 μm, and is more preferably 3 μm to 10 μm.

<Preparation method of the filter layer for the optical recording medium containing cholesteric liquid crystal layer>

There is not any particular restriction with the preparation method of the filter layer for the optical recording medium, and it is appropriately selected on purpose.

There is not any particular restriction with the filter layer for the optical recording medium, it is appropriately selected on purpose, and it is preferred to be arranged on the second substrate of the optical recording medium by processed (punched out, for example) to be a disk shape together with a base material. In case on applying as the filter layer for the optical recording medium, it can be directly arranged on the second substrate without a base material.

<Base material>

The base material is not particularly limited and can be appropriately selected depending on the intended purpose. For example, materials used for the foregoing support for the first embodiment may be used.

The base material may be either a freshly prepared one or a commercially available one.

The thickness of the base material is not particularly limited and can be appropriately set depending on the intended purpose. The thickness is preferably 10 μm to 500 μm, and is more preferably 50 μm to 300 μm. If the thickness of the base material is less than 10 μm, the substrate bends and thus its adhesion properties with other components are reduced. If the thickness of the base material is more than 500 μm, the focus point of information light needs to be shifted from the focus of reference light at a large amount, and thus it requires a big optical system. In order to laminate to form the cholesteric liquid crystal layer, known adhesives or tackiness agents can be arbitrary selected, and used in

combination.

The adhesive is not particularly limited and can be appropriately selected depending on the intended purpose. Examples thereof include UV curable adhesives, emulsion adhesives, one-component curable adhesives and two-component curable adhesives. These known adhesives can be used in any combination.

The tackiness agent is not particularly limited and can be appropriately selected depending on the intended purpose; examples thereof include rubber agents, acrylic agents, silicone agents, urethane agents, vinylalkyl ether agents, polyvinylalcohol agents, polyvinylpyrrolidone agents, polyacrylamide agents and cellulose agents.

The applied thickness of the adhesive or agglutinant is not particularly limited and can be appropriately set depending on the intended purpose. In the case of adhesive, the thickness is preferably 0.1 μm to 10 μm, more preferably 0.1 μm to 5 μm in light of the optical characteristics and slimness. In the case of agglutinant, the thickness is preferably 1 μm to 50 μm, more preferably 2 μm to 30 μm.

The filter layer can be formed directly on the substrate on occasion.

-Optical recording medium having a reflective film, and first and second gap layers-

The optical recording medium includes a first substrate, a second substrate, a recording layer disposed between the first substrate and the second substrate, and a filter layer disposed between the second substrate and the recording layer. The optical recording medium may further include a reflective film, a first gap layer and a second gap layer, and other layers, if necessary.

-Substrate-

The shape, structure, size and the like of the substrate are not particularly limited and can be appropriately set depending on the intended purpose. Examples of the shape of the substrate includes a disc shape and card-like shape. The material that can ensure the mechanical strength of the resultant optical recording medium needs to be selected for the substrate. In addition, when light for recording and reproduction is incident through the substrate, the substrate needs to be transparent enough at the predetermined wavelengths of the light for use.

For the material of the substrate, glass, ceramics, resins and the like are generally used. However, the resin is most preferable in view of the formability and cost.

Examples of the resins include polycarbonate resins, acrylic resins, epoxy resins, polystyrene resins, acrylonitrile-styrene copolymers, polyethylene resins, polypropylene resins, silicone resins, fluorine resins, ABS resins and urethane resins. Among these, polycarbonate resins and acrylic resins are most preferable in view of their formability, optical characteristics, and costs.

The substrate may be either a freshly prepared one or a commercially available one.

Multiple numbers of address-servo areas - addressing areas linearly extending in the radial direction of the substrate - are provided on the substrate at given angles to one another, and each fan-shaped area between adjacent address-servo areas serves as a data area. In the address-servo areas, information for performing a focus servo operation and a tracking servo operation by means of a sampled servo system and address information are previously recorded (or pre-formatted) in the form of emboss pits (servo pits). The focus servo operation can be performed using a reflective surface of the reflective film. For example, wobble pits are used as the information for tracking servo. Note that there is no need to provide the servo pit pattern in a case where the optical recording medium is card-like shape.

The thickness of the substrate is not particularly limited and can be appropriately set depending on the intended purpose; the thickness is preferably 0.1 mm to 5 mm, and is more preferably 0.3 mm to 2 mm. If the thickness of the substrate is less than 0.1 mm, the optical disc may become deformed during storage. If the thickness is more than 5 mm, the weight of the optical disc is increased, so too does the load on a drive motor that spins it.

-Reflective film-

The reflective film is formed on the surface of the servo pit pattern of the substrate.

For the material of the reflective film, materials that offer high reflectivity to recording light and reference light are preferable. When the wavelength of light to be adopted is 400 nm to 780 nm, Al, A1 alloys, Ag, Ag alloys and the like are preferably used. When the wavelength of light to be adopted is 650 nm or more, Al, Al alloys, Ag. Ag alloys, Au, Cu alloys, TiN and the like are preferably used.

By using an optical recording medium which reflects light by a reflective film and can record or erase information - for example, DVD (Digital Versatile (Video) Disc), directory information indicative of the locations where information has been recorded, the time when information has been recorded, and the locations where errors have occurred and how information has been re-recorded on spare areas can also be recorded on, and erased from the optical recording medium without adversely affecting holograms.

The method for forming the reflective film is not particularly limited and can be appropriately selected depending on the intended purpose; examples thereof include various types of vapor deposition, such as a vacuum vapor deposition, sputtering, plasma CVD, photo CVD, ion plating, and electron beam vapor deposition. Among these, sputtering is most preferable in view of mass productivity, film quality, and the like.
The thickness of the reflective film is preferably 50 nm or more, and is more preferably 100 nm or more, in order to secure sufficient reflectivity.

-First gap layer-

The first gap layer is provided between the filter layer and the reflective film on an as-needed basis for smoothing the surface of the second substrate. Moreover, the first gap layer is effective to adjust the size of holograms formed in the recording layer. Specifically, since somewhat large regions where optical interference between information light and recording reference light takes place need to be secured in the recording layer, it is effective to provide the first gap layer between the recording layer and the servo pit pattern.
The first gap layer can be formed by, for example, applying UV curable resin or the like on the servo pit pattern by spin coating or the like and by curing the resin. In addition, when a filter layer is formed on a transparent base material, the transparent base material also serves as the first gap layer.
The thickness of the first gap layer is not particularly limited and can be appropriately set depending on the intended purpose. The thickness is preferably 1 $\mu$m to 200 $\mu$m.

-Second gap layer-

The second gap layer is provided between the recording layer and the filter layer on an as-needed basis.
The material for the second gap layer is not particularly limited and can be appropriately selected depending on the intended purpose; examples thereof include transparent resin films such as triacetylcellulose (TAC), polycarbonate (PC), polyethylene terephthalate (PET), polystyrene (PS), polysulfone (PSF), polyvinylalcohol (PVA) and methyl polymethacrylate (PMMA); norbornene resin films such as ARTON (bland name, produced by JSR Corp.), ZEONOA (bland name, produced by Nippon Zeon). Among these, those with high isotropy are preferable, and TAC, PC, ARTON and ZEONOA are most preferable.
The thickness of the second gap layer is not particularly limited and can be appropriately set depending on the intended purpose; the thickness is preferably 1 $\mu$m to 200 $\mu$m.
Hereinafter, operative examples 1 to 6 of the optical recording medium of the present invention, which includes the reflective film and the first and second gap layers, will be described in detail with reference to the drawings.

<Operative Example 1 of the optical recording medium>

FIG. 5 is a schematic cross-sectional view showing the structure of Operative Example 1 of the optical recording medium in the present invention. In an optical recording medium 21 according to Operative Example 1, a servo pit pattern 3 is formed on a second substrate 1 made of polycarbonate resin or glass, and the serve pit pattern 3 is coated with Al, Au, Pt or the like to form a reflective film 2. Although the servo pit pattern 3 is formed on the entire surface of the second substrate 1 in FIG. 5, it may be formed on the second substrate 1 periodically as shown in FIG. 4. In addition, the height of the servo pit pattern 3 is generally 175 nm (1,750 angstrom), far smaller than those of the other layers, including substrates.
A first gap layer 8 is formed by applying UV curable resin or the like on the reflective film 2 of the second substrate 1 by spin coating or the like. The first gap layer 8 is effective for protecting the reflective film 2 and for adjusting the size of holograms created in a recording layer 4. Specifically, since somewhat large regions where optical interference between information light and recording reference light takes place need to be secured in the recording layer 4, it is effective to provide clearance between the recording layer 4 and the servo pit pattern 3.
A filter layer 6 is provided on the first gap layer 8, and the recording layer 4 is sandwiched between the filter layer 6 and a first substrate (a polycarbonate resin substrate or glass substrate) to constitute the optical recording medium 21.
In FIG. 5, the filter layer 6 admits only red light 10 and reflects light of the other colors. Therefore, the information light and recording and reproduction reference light 11 do not pass through the filter layer 6 because they are light of green or blue, and never reach the reflective film 2, becoming returning light emitting from the light entrance/ exit surface A.
The filter layer 6 is constituted of a single-layered cholesteric liquid crystal layer whose helical pitch is continuously changed in the thickness direction thereof. The filter layer 6 may be directly provided on the first gap layer 8 with a coating method, or may be provided by stamping a film in which a cholesteric liquid crystal layer is formed on a base material into the optical disc shape. By using such a single-layered cholesteric liquid crystal layer, optical transmittance

of 40% or more can be realized for light of a wavelength range of $\lambda_0$ to $\lambda_0$/cos20°, especially $\lambda_0$ to $\lambda_0$/cos40° (where $\lambda_0$ represents the wavelength of irradiation light), thereby eliminating the fluctuations in the selectively-reflecting wavelength range even when the incident angle has changed.

The optical recording medium 21 of Operative Example 1 may be a disc shape or card-like shape. There is no need to provide a servo pit pattern in a case where the optical recording medium 21 is a card-like shape. In the optical recording medium 21 the second substrate 1 is 0.6 mm in thickness, the first gap layer 8 is 100 μm in thickness, the filter layer 6 is 2 μm to 3 μm in thickness, the recording layer 4 is 0.6 mm in thickness, and the first substrate 5 is 0.6 mm in thickness, bringing to the total to about 1.9 mm.

Next, optical operations around the optical recording medium 21 will be described with reference to FIG.11.

First, a red light beam 10 emitted from the servo laser source is reflected by a dichroic mirror 13 by almost 100%, and passes through an objective lens 12. By this, the servo light 10 is applied onto the optical recording medium 21 in such a way that it focuses on the reflective film 2. More specifically, the dichroic mirror 13 is so configured that it admits only green or blue light but reflects almost 100% of red light. The servo light incident from the light entrance/ exit surface A of the optical recording medium 21 passes through the first substrate 5, recording layer 4, filter layer 6 and first gap layer 8, is reflected by the reflective film 2, and passes again through the first gap layer 8, filter layer 6, recording layer 4 and first substrate 5 to emit from the light entrance/ exit surface A. The returning servo light passes through the objective lens 12 and is reflected by the dichroic mirror by almost 100%, and then a servo information detector (not shown) detects servo information in the returning servo light. The detected servo information is used for the focus servo operation, tracking servo operation, slide servo operation, and the like. The holographic material containing the recording layer 4 is designed so as not to be sensitive to red light. For this reason, even when the servo light has passed through the recording layer 4 or has been reflected diffusively by the reflective film 2, the recording layer 4 is not adversely affected. In addition, the returning servo light that has been reflected by the reflective film 2 is reflected by the dichroic mirror 13. Accordingly, the servo light is not detected by a CMOS sensor or CCD 14 used for the detection of reconstructed images, and thus does not interfere with the operation of reproduction light.

Note that with respect to the reflection range of $\lambda_0$ to $1.3\lambda_0$, $1.3\lambda_0$ shown in FIG. 13, $1.3\lambda_0$ equals to 692 nm when $\lambda_0$ is 532 nm, and thus servo light of wavelength 655 nm is undesirably reflected. This reflection range is set in view of light incident at an angle of ±40°. However, when such light that is incident at larger angles is intended to be used, a servo operation can be performed without causing any problems by using servo light incident at an angle of within ±20° that has been masked. In addition, by securing larger helical pitch in the cholesteric liquid crystal layer in the filter layer used, it is also possible to readily cover servo light incident to the filter layer at an angle of within ±20°. In that case, it is only necessary to prepare a cholesteric liquid crystal layer with a reflection range of $\lambda_0$ to $1.1\lambda_0$ as shown in FIG. 14. Thus, transmittance of the servo light entails no difficulty.

Both the information light and recording reference light 11 generated in the recording/reproduction laser source pass through a polarizing plate 16 and are linearly polarized. The linearly polarized information and recording reference light then passes through a half mirror 17 and is circularly polarized after passing through a quarter wave plate 15. The circularly polarized light then passes through the dichroic mirror 13 and the objective lens 12, and is applied onto the optical recording media 21 in such a way that optical interference takes place between the information light and reference light to create interference images in the recording layer 4. The information light and reference light are incident from the light entrance/exit surface A and interact with each other in the recording layer 4 to form an interference image to be recorded there. Thereafter, the information light and reference light pass through the recording layer 4, launching into the filter layer 6. There, before reaching the bottom of the filter layer 6, the information light and reference light are reflected and become returning light. More specifically, the information light and recording reference light do not reach the reflective film 2. This is because the filter layer 6 is formed of a single-layered cholesteric liquid crystal layer whose helical pitch is continuously changed in the thickness direction thereof and thus admits only red light. Moreover, if the intensity of light that has undesirably passed through the filter layer 6 is suppressed to 20% or less of that of the incident light, there will be no practical problems even when such light reaches the bottom of the filter layer 6 and is reflected back as returning light, because this returning light is again reflected by the filter layer 6 and its intensity in reproduction light is as small as 4% (20% x 20%) or less of that of the reproduction light 11'.

<Operative Example 2 of the optical recording medium>

FIG. 6 is a schematic cross-sectional view showing the structure of Operative Example 2 of the optical recording medium in the present invention. In an optical recording medium 22 according to Operative Example 2, a servo pit pattern 3 is formed on a second substrate 1 made of polycarbonate resin or glass, and the serve pit pattern 3 is coated with Al, Au, Pt or the like to form a reflective film 2. The height of the servo pit pattern 3 is generally 1750 angstrom (175 nm), as in the case of the first embodiment.

Operative Example 2 differs from Operative Example 1 in that the optical recording medium 22 has a second gap layer 7 provided between the filter layer 6 and the recording layer 4.

The filter layer 6 constituted of a single-layered cholesteric liquid crystal layer whose helical pitch is continuously changed in the thickness direction thereof is formed on a first gap layer 8 that has been previously formed. A filter layer similar to that described of Operative Example 1 can be used.

In the second gap layer 7 there is a point at which both information light and reference light focus; if this area is embedded in photopolymers, excessive exposure takes places and thus an excess amount of monomers are consumed, leading to poor multiplexing recording performance. To avoid this, it is effective to provide a transparent, inert second gap layer.

In the optical recording medium 22 the second substrate 1 is 1.0 mm in thickness, the first gap layer 8 is 100 μm in thickness, the filter layer 6 is 3 μm to 5 μm in thickness, the second gap layer 7 is 70 μm in thickness, the recording layer 4 is 0.6 mm in thickness, and the first substrate 5 is 0.4 mm in thickness, bringing to the total to about 2.2 mm.

Upon recording and reproduction of information, the optical recording medium 22 having the structure described above is irradiated with red servo light and green information light and green recording and reproduction reference light. The servo light is incident from the light entrance/exit surface A, passes through the recording layer 4, second gap layer 7, filter layer 6 and first gap layer 8, and is reflected by the reflective film 2 to become returning servo light. This returning servo light sequentially passes through the first gap layer 8, filter layer 6, second gap layer 7, recording layer 4 and first substrate 5 again, and emits from the light entrance/ exit surface A. The emitted returning servo light is used for the focus servo operation, tracking servo operation, and the like. The holographic material constituting the recording layer 4 is designed so as not to be sensitive to red light. For this reason, even when the servo light has passed through the recording layer 4 or has been reflected diffusively by the reflective film 2, the recording layer 4 is not adversely affected. The green information light and reference light are incident from the light entrance/ exit surface A and pass through the recording layer 4 and second gap layer 7, and reflected by the filter layer 6 to become returning light. The returning light sequentially passes through the second gap layer 7, recording layer 4 and first substrate 5, and emits from the light entrance/exit surface A. Upon reproduction of information, both reproduction reference light and reproduction light generated by irradiating the recording layer 4 with the reproduction reference light do not reach the reflective film 2 and emit from the light entrance/ exit surface A. Note that the optical operations around the optical recording medium 22 (i.e., the objective lens 12, filter layer 6, CMOS sensor or CCD 14 in FIG. 11) are similar to those in Operative Example 1 (FIG. 11), and the description thereof is omitted.

<Operative Example 3 of the optical recording medium>

FIG. 7 is a schematic cross-sectional view showing the structure of Operative Example 3 of the optical recording medium in the present invention. This optical recording medium 21 according to Operative Example 3 is similar to that of Operative Example 1 except for the configuration of the filter layer 6.

In FIG. 7, the filter layer 6 admits only red light and reflects light of the other colors. Therefore, the information light and recording and reproduction light do not pass through the filter layer 6 because they are light of green or blue, and never reach the reflective film 2, becoming returning light emitting from the light entrance/exit surface A.

The filter layer 6 is a laminate of seven dielectric thin layers with different indices of refractive-index formed on a colored material-containing layer 6b. The filter layer 6, where the dielectric thin layers and a colored material-containing layer are combined, may be directly formed on the first gap layer 8 with a coating or deposition method, or may be formed by stamping a film, in which dielectric thin layers and a colored material-containing layer is formed on a base material, into the optical disc shape. Using such a filter layer leads to optical transmittance of 50% or more for light of wavelength 655 nm and 30% or more for light of wavelength 532 nm, both incident at an angle of within ±40°, thereby eliminating the fluctuations in the selectively-reflecting wavelength range even when the incident angle has changed.

The optical recording medium 21 of Operative Example 3 may be a disc shape or card-like shape. There is no need to provide a servo pit pattern in a case where the optical recording medium 21 is a card-like shape.

Next, optical operations around the optical recording medium 21 will be described with reference to FIG. 11.

First, a red light beam emitted from the servo laser source is reflected by the dichroic mirror 13 by almost 100%, and passes through the objective lens 12. By this, the servo light is applied onto the optical recording medium 21 in such a way that it focuses on the reflective film 2. More specifically, the dichroic mirror 13 is so configured that it admits only green or blue light but reflects almost 100% of red light. The servo light incident from the light entrance/exit surface A of the optical recording medium 21 passes through the first substrate 5, recording layer 4, filter layer 6 and first gap layer 8, is reflected by the reflective film 2, and passes again through the first gap layer 8, filter layer 6, recording layer 4 and first substrate 5 to emit from the light entrance/exit surface A. The returning servo light passes through the objective lens 12 and is reflected by the dichroic mirror by almost 100%, and then the servo information detector (not shown) detects servo information in the returning servo light. The detected servo information is used for the focus servo operation, tracking servo operation, slide servo operation, and the like. The holographic material constituting the recording layer 4 is designed so as not to be sensitive to red light. For this reason, even when the servo light has passed through the recording layer 4 or has been reflected diffusively by the reflective film 2, the recording layer 4 is not adversely affected.

In addition, the returning servo light that has been reflected by the reflective film 2 is reflected by the dichroic mirror 13. Accordingly, the servo light is not detected by a CMOS sensor or CCD 14 used for the detection of reconstructed images, and thus does not interfere with the operation of reproduction light.

Both the information light and recording reference light generated in the recording/reproduction laser source pass through the polarizing plate 16 and are linearly polarized. The linearly polarized information and recording reference light then passes through the half mirror 17 and is circularly polarized after passing through the quarter wave plate 15. The circularly polarized light then passes through the dichroic mirror 13 and the objective lens 12, and is applied onto the optical recording media 21 in such a way that optical interference takes place between the information light and recording reference light to create interference images in the recording layer 4. The information light and recording reference light are incident from the light entrance/exit surface A and interact with each other in the recording layer 4 to form an interference image to be recorded there. Thereafter, the information light and recording reference light pass through the recording layer 4, launching into the filter layer 6. There, before reaching the bottom of the filter layer 6, the information light and recording reference light are reflected and become returning light. More specifically, the information light and recording reference light do not reach the reflective film 2. This is because the filter layer 6 is a laminate in which a colored material-containing layer and dielectric thin films are combined, and thus admits only red light. Moreover, if the intensity of light that has undesirably passed through the filter layer 6 is suppressed to 20% or less of that of the incident light, there will be no practical problems even when such light reaches the bottom of the filter layer 6 and is reflected back as returning light, because this returning light is again reflected by the filter layer 6 and its intensity in reproduction light is as small as 4% (20% x 20%) or less of that of the reproduction light.

<Operative Example 4 of the optical recording medium>

FIG. 8 is a schematic cross-sectional view showing the structure of Operative Example 4 of the optical recording medium in the present invention. This optical recording medium 22 according to the second embodiment is similar to that of Operative Example 1 except for the configuration of the filter layer 6.

Operative Example 4 differs from Operative Example 3 in that the optical recording medium 22 according to Operative Example 4 has a second gap layer 7 provided between the filter layer 6 and the recording layer 4.

The filter layer 6, in which a colored material-containing layer and a dielectric material-deposited layer are combined, is formed on a first gap layer 8 that has been previously formed. A filter layer similar to that of the first embodiment can be used.

In the second gap layer 7 there is a point at which both information light and reference light focus; if this area is embedded in photopolymers, excessive exposure takes places and thus an excess amount of monomers are consumed, leading to poor multiplexing recording performance. To avoid this, it is effective to provide a transparent, inert second gap layer.

In the optical recording medium 22 the first and second substrates 1 and 5 are produced in a similar way as those of Operative Example 2.

Upon recording and reproduction of information, the optical recording medium 22 having the structure described above is irradiated with red servo light and green information light and green recording and reproduction reference light. The servo light is incident from the light entrance/ exit surface A, passes through the recording layer 4, second gap layer 7, filter layer 6 and first gap layer 8, and is reflected by the reflective film 2 to become returning servo light. This returning servo light sequentially passes through the first gap layer 8, filter layer 6, second gap layer 7, recording layer 4 and first substrate 5 again, and emits from the light entrance/exit surface A. The emitted returning servo light is used for the focus servo operation, tracking servo operation, and the like. The holographic material constituting the recording layer 4 is designed so as not to be sensitive to red light. For this reason, even when the servo light has passed through the recording layer 4 or has been reflected diffusively by the reflective film 2, the recording layer 4 is not adversely affected. The green information light and reference light are incident from the light entrance/exit surface A and pass through the recording layer 4 and second gap layer 7, and reflected by the filter layer 6 to become returning light. The returning light sequentially passes through the second gap layer 7, recording layer 4 and first substrate 5, and emits from the light entrance/exit surface A. Upon reproduction of information, both reproduction reference light and reproduction light generated by irradiating the recording layer 4 with the reproduction reference light do not reach the reflective film 2 and emit from the light entrance/ exit surface A. Note that the optical operations around the optical recording medium 22 (i.e., the objective lens 12, filter layer 6, CMOS sensor or CCD 14 in FIG. 11) are similar to those in Operative Example 3 (FIG. 11), and the description thereof is omitted.

<Operative Example 5 of the optical recording medium>

Hereinafter, Operative Example 5 of the optical recording medium will be described in detail with reference to the drawing.

FIG. 9 is a schematic cross-sectional view showing the structure of Operative Example 5 of the optical recording medium in the present invention. This optical recording medium 21 according to Operative Example 5 is similar to that of Operative Example 1 except for the configuration of the filter layer 6.

The first gap layer 8 is formed by applying UV curable resin or the like on the reflective film 2 of the second substrate 1 by spin coating or the like. The first gap layer 8 is effective for protecting the reflective film 2 and for adjusting the size of holograms created in the recording layer 4. Specifically, since somewhat large regions where optical interference between information light and recording reference light takes place need to be secured in the recording layer 4, it is effective to provide clearance between the recording layer 4 and the servo pit pattern 3.

The filter layer 6 is provided on the first gap layer 8, and the recording layer 4 is sandwiched between the filter layer 6 and a first substrate (a polycarbonate resin substrate or glass substrate) to constitute the optical recording medium 21.

In FIG. 9, the filter layer 6 admits only red light and reflects light of the other colors. Therefore, the information light and recording and reproduction reference light do not pass through the filter layer 6 because they are light of green or blue, and never reach the reflective film 2, becoming returning light emitting from the light entrance/exit surface A.

The filter layer 6 is a laminate of three cholesteric liquid crystal layers 6c, 6d and 6e. The filter layer 6 may be directly provided on the first gap layer 8 with a coating method, or may be provided by stamping a film in which three cholesteric liquid crystal layers are formed on a base material into the optical disc shape. By using such a filter layer, optical transmittance of 40% or more can be realized for light of a wavelength range of $\lambda_0$ to $\lambda_0$/cos20°, especially $\lambda_0$ to $\lambda_0$/cos40° (where $\lambda_0$ represents the wavelength of irradiation light), thereby eliminating the fluctuations in the selectively-reflecting wavelength range even when the incident angle has changed.

The optical recording medium 21 of Operative Example 5 may be a disc shape or card-like shape, and is formed in a similar manner as that of Operative Example 1.

Optical operations around the optical recording medium 21 are similar to those in Operative Examples 1 and 2. Note that with respect to the reflection range of $\lambda_0$ to 1.3$\lambda_0$, 1.3$\lambda_0$ shown in FIG. 15, 1.3$\lambda_0$ equals to 692 nm when $\lambda_0$ is 532 nm, and thus servo light of wavelength 655 nm is undesirably reflected. This reflection range is set in view of light incident at an angle of ±40°. However, when such light that is incident at larger angles is intended to be used, a servo operation can be performed without causing any problems by using servo light incident at an angle of within ±20° that has been masked. In addition, by securing larger helical pitch in the cholesteric liquid crystal layer in the filter layer used, it is also possible to readily cover servo light incident to the filter layer an angle of within ±20°. In that case, it is only necessary to prepare a laminate of two cholesteric liquid crystal layer with a reflection range of $\lambda_0$ to 1.1$\lambda_0$ as shown in FIG. 16. Thus, transmittance of the servo light entails no difficulty.

Both the information light and recording reference light generated in the recording/reproduction laser source pass through the polarizing plate 16 and are linearly polarized. The linearly polarized information and recording reference light then passes through the half mirror 17 and is circularly polarized after passing through the quarter wave plate 15. The circularly polarized light then passes through the dichroic mirror 13 and the objective lens 12, and is applied onto the optical recording media 21 in such a way that optical interference takes place between the information light and recording reference light to create interference images in the recording layer 4. The information light and recording reference light are incident from the light entrance/ exit surface A and interact with each other in the recording layer 4 to form an interference image to be recorded there. Thereafter, the information light and recording reference light pass through the recording layer 4, launching into the filter layer 6. There, before reaching the bottom of the filter layer 6, the information light and recording reference light are reflected and become returning light. More specifically, the information light and recording reference light do not reach the reflective film 2. This is because the filter layer 6 is a laminate of three cholesteric liquid crystal layers and thus admits only red light. Moreover, if the intensity of light that has undesirably passed through the filter layer 6 is suppressed to 20% or less of that of the incident light, there will be no practical problems even when such light reaches the bottom of the filter layer 6 and is reflected back as returning light, because this returning light is again reflected by the filter layer 6 and its intensity in reproduction light is as small as 4% (20% x 20%) or less of that of the reproduction light.

<Operative Example 6 of the optical recording medium>

FIG. 10 is a schematic cross-sectional view showing the structure of Operative Example 6 of the optical recording medium in the present invention. This optical recording medium 22 according to Operative Example 6 is similar to that of Operative Example 1 except for the configuration of the filter layer 6.

Operative Example 6 differs from Operative Example 5 in that the optical recording medium 22 according to Operative Example 6 has a second gap layer 7 provided between the filter layer 6 and the recording layer 4.

The filter layer 6 in which three cholesteric liquid crystal layers are laminated is formed on a first gap layer 8 that has been previously formed. A filter layer similar to that of first embodiment can be used.

In the second gap layer 7 there is a point at which both information light and reference light focus; if this area

is embedded in photopolymers, excessive exposure takes places and thus an excess amount of monomers are consumed, leading to poor multiplexing recording performance. To avoid this, it is effective to provide a transparent, inert second gap layer.

In the optical recording medium 22 the first and second substrates 1 and 5 are produced in a similar way as those of Operative Example 2.

Upon recording and reproduction of information, the optical recording medium 22 having the structure described above is irradiated with red servo light and green information light and green recording and reproduction reference light. The servo light is incident from the light entrance/exit surface A, passes through the recording layer 4, second gap layer 7, filter layer 6 and first gap layer 8, and is reflected by the reflective film 2 to become returning servo light. This returning servo light sequentially passes through the first gap layer 8, filter layer 6, second gap layer 7, recording layer 4 and first substrate 5 again, and emits from the light entrance/exit surface A. The emitted returning servo light is used for the focus servo operation, tracking servo operation, and the like. The holographic material constituting the recording layer 4 is designed so as not to be sensitive to red light. For this reason, even when the servo light has passed through the recording layer 4 or has been reflected diffusively by the reflective film 2, the recording layer 4 is not adversely affected. The green information light and reference light are incident from the light entrance/ exit surface A and pass through the recording layer 4 and second gap layer 7, and reflected by the filter layer 6 to become returning light. The returning light sequentially pass through the second gap layer 7, recording layer 4 and first substrate 5, and emit from the light entrance/ exit surface A. Upon reproduction of information, both reproduction reference light and reproduction light generated by irradiating the recording layer 4 with the reproduction reference light do not reach the reflective film 2 and emit from the light entrance/ exit surface A. Note that the optical operations around the optical recording medium 22 (i.e., the objective lens 12, filter layer 6, CMOS sensor or CCD 14 in FIG.11) are similar to those in Operative Example 5 (FIG.11), and the description thereof is omitted.

(Method for manufacturing the optical recording medium)

The method for manufacturing the optical recording medium of the present invention contains a filter layer formation step, a reflective film formation step and a recording layer formation step, and further contains other steps, if necessary.

-Filter layer formation step-

The filter layer formation step is a step in which the filter for optical recording medium of the present invention is processed into the optical recording medium shape, and the processed filter is bonded to the second substrate to form a filter layer.

The process for producing the filter for the optical recording medium of the present invention is as described above.

The shape of the optical recording medium is, for example, disc shape or card-like shape.

The method for processing the filter into a shape of the optical recording medium is not particularly limited, and can be appropriately selected depending on the intended purpose. For example, a cutting process with a press cutter, or a stamping process with a stamping cutter can be used.

The filter is bonded to the second substrate by use of, for example, an adhesive or tackiness agent in a manner such that any air is not captured therebetween.

The adhesive is not particularly limited and can be appropriately selected depending on the intended purpose. Examples thereof include UV curable adhesives, emulsion adhesives, one-component curable adhesives and two-component curable adhesives. These known adhesives can be used in any combination.

The tackiness agent is not particularly limited and can be appropriately selected depending on the intended purpose; examples thereof include rubber agents, acrylic agents, silicone agents, urethane agents, vinylalkyl ether agents, polyvinylalcohol agents, polyvinylpyrrolidone agents, polyacrylamide agents and cellulose agents.

The applied thickness of the adhesive or agglutinant is not particularly limited and can be appropriately set depending on the intended purpose. In the case of adhesive, the thickness is preferably 0.1 $\mu$m to 10 $\mu$m, more preferably 0.1 $\mu$m to 5 $\mu$m in light of the optical characteristics and slimness. In the case of agglutinant, the thickness is preferably 1 $\mu$m to 50 $\mu$m, more preferably 2 $\mu$m to 30 $\mu$m.

Note, however, that it is possible to directly form the filter layer on the substrate depending on the circumstances. For example, a coating solution for colored material-containing layer is applied onto the substrate to form a colored material-containing layer, and a dielectric thin film is formed on the colored material-containing layer by sputtering or the like.

[Examples]

Hereinafter, Examples of the present invention will be described, which however shall not be construed as limiting the invention thereto.

(Example 1)

(1) Preparation of a recording layer-coating solution

Described as below, a mixed solution (I), a microcapsule solution (II), and a microcapsule solution (III) were sequentially prepared to yield a recording layer-coating solution.
At first, to 16.1 g of ethyl acetate, there were added 4.4 g of a diazonium salt compound (Compound 17), 4.8g of squalane, and 4.8 g of monoisopropylbiphenyl, and the mixture was heated at 40°C, and uniformly dissolved. To this mixed solution, there was added 8.6 g of a mixture of xylenediisocyanate-trimethylolpropane adduct and xylenediisocyanate-bisphenol A adduct (product name: Takenate D119N (50% by mass ethylacetate solution), the manufacturer: Takeda Pharmaceutical Co., Ltd.) as a capsule shell material, and the mixture was uniformly stirred uniform to thereby yield the mixed solution (I).
To the mixed solution (I), there was added 85 g of 10% by mass polyvinyl alcohol aqueous solution (product name: PVA-105, the manufacturer: KURARAY CO., LTD., saponification degree: 98% to 99%), and the mixture was emulsified and dispersed by means of with a homogenizer (the manufacturer: NISSEI Corp.) at the external temperature of 10°C to thereby obtain an emulsion. To the obtained emulsion, there was added and uniformly mixed 20g of water, the emulsion solution was stirred at the external temperature of 40°C three hours to remove the ethylacetate and to proceed with a capsulation reaction. Thereafter, 4.1 g of ion exchange resin Amberlite IRA 68 (by ORGANO Corp.), and 8.2 g of ion exchange resin Amberlite IRC 50 (by ORGANO Corp.) were added thereto, and stirred further for one hour. After stopped stirring, the mixture was subjected to filtration so as to remove the ion exchange resins therefrom, and the water therein was evaporated slowly in order to adjust the solids content of the solution to be 50%, to thereby yield a microcapsule solution (II) which contains microcapsules each encapsulating the diazonium salt compound. The particle diameter of the obtained microcapsule was 0.23 μm with Median diameter, and the measurement was taken by a particle size analyzer (product name: LA-700, the manufacturer: Horiba Ltd.).
Thereafter, the microcapsule solution (II) was subjected to a classification by centrifugal separation in accordance with the method as described in JP-A 2005-96124, photographed with scanning electron microscope (SEM), and measured the particle diameter with the photograph analysis to thereby prepare the microcapsule solution (III) having the particle diameter of 0.07 μm with Median diameter (voluminous standard). In this manner, a recording layer-coating solution was prepared as the microcapsule solution (III).

(2) Preparation of a recording layer sheet

On a silicon wafer, four Teflon™ sheets were bonded to form a bank, and a pool for the recording layer-coating solution to be poured was prepared. Specifically, an adhesive was applied as thin and uniform as possible on the Teflon (TM) sheet with 10mm width, 10cm length, and 700μm thickness, and the pool with 10 cm width and length, and 700μm depth was built.
Then the microcapsule solution (III) was poured into the pool. The poured amount of the microcapsule solution (III) was determined so that a dried film had a thickness of 100 μm after evaporating 95% of the water from the solution. It was dried under the condition of the temperature at 40°C, and the relative humidity at 30% to thereby yield a sheet having a thickness of 100 μm ± 2 μm. This procedure was repeated five times in order to obtain a recording layer sheet having a thickness of 500 μm. The recording layer sheet is cut and peeled out so as to have a cross section area of 5cm x 5cm to thereby obtain a recording layer sheet.

(3) Preparation of an optical recoding medium

One surface of a glass sheet having a thickness of 0.5 mm was subjected to a reflection prevention treatment so as to give a reflectivity of 0.1% with respect to a normal incident having a wavelength of 532 nm, to thereby obtain a first substrate. One surface of another glass sheet having a thickness of 0.5 mm was subjected to a aluminum deposition so as to give a reflectivity of 90% with respect to a normal incident having a wavelength of 532 nm, to thereby obtain a second substrate. Then, the recording layer sheet was bonded on a surface of the first substrate where with the reflection prevention treatment was not performed, while performing a silane coupling treatment thereon. As a spacer, a transparent polyethyleneterephthalate sheet having a thickness of 500 μm was disposed on the recording layer, and the other surface of the spacer was bonded to the side of the second substrate where the aluminum had been deposited, so as not to

trap any air therebetween, to thereby obtain an optical recording medium.

(4) Recording and evaluation of the optical recording medium

By means of a collinear hologram recording and reproducing examiner SHOT-1000 produced by PULSTEC INDUSTRIAL CO., LTD., the prepared optical recording medium was subjected to a writing of a series of multiplex holograms with a recording spot diameter of 200 μm at the focal point of the hologram recording. The recorded holograms were measured and evaluated in terms of photosensitivity (recording energy) and multiplex index.

<Measurement of photosensitivity>

The radiation power was varied at the time of recording, and a variation of a bit error rate (BER) of the reproduction signal was measured. Generally speaking, as the power of the recording light is increased, the brightness of the reproduction signal is increased, and the BER of the reproduction signal tends to be gradually decreased. In this case, the recording photosensitivity was determined with the minimum recording radiation power which provided the almost clear reproduced image (BER < $10^{-3}$). As a result, the condition BER < $10^{-3}$ was gained with the recording sensitivity (recording radiation power) at 75 $mJ/cm^2$.

<Evaluation of multiplex index>

As a multiplex index evaluation for the optical recording medium, a method described in ISOM '04, Th-J-06, pp. 184 to 185, Oct., 2004 was applied and performed. In this method, a recording spot was made shifted in a spiral direction to evaluate the multiplex index. Here, the number of the recorded hologram was set at 13 x 13=169 holograms, and the recording pitch was set at 28.5 μm. The multiplex index at the final (169th) hologram recording was 49. As the number of the recorded holograms are increased, the multiplex index is increased. In the case where the multiplex index of the recording material is insufficient, the BER is therefore increased as the number of the recorded hologram is increased. Accordingly, a number of the recording hologram volume at BER > $10^{-3}$ was determined as the multiplex property M of the recording material.

In this way, it was confirmed that the multiplex property M was 121.

(5) Originality conservativeness of the optical recording medium

The evaluation of the storage stability of the optical recording medium before practical use (the storage stability of the raw recording material) was performed, by storing the optical recording medium under the enforced condition as below, evaluating the recording sensitivity and multiplex index in the aforementioned manner, and comparing the difference in the results before and after the storage.

(a) Stored in a room of the constant temperature and humidity at 40°C, 90%RH for 24 hours.
(b) Stored in a room of the constant temperature and humidity at 60°C, 30%RH for 24 hours.

As a result, it was found that, the optical recording medium of (a) had a recording sensitivity of 75 $mJ/cm^2$, and the optical recording medium of (b) had a recording sensitivity of 76$mJ/cm^2$. Compared with the recording sensitivity of the optical recording medium before the storage, i.e., 75 $mJ/cm^2$, the recording sensitivity of the optical recording medium after the storage was maintained almost the same to that of the optical recording medium before the storage. Moreover, it was found that, the optical recording medium of (a) had multiplex property M of 121, and the optical recording medium of (b) had multiplex property M of 121. Compared with the multiplex property M of the optical recording medium before the storage, i.e., 121, the recording sensitivity of the optical recording medium after the storage was maintained the same to that of the optical recording medium before the storage.

(Example 2)

An optical recording medium was prepared in the same manner as in Example 1, provided that 4.4 g of the diazonium salt compound (Compound 17) was replaced with 4.2 g of the diazonium salt compound (Compound 1). The prepared optical recording medium was evaluated in terms of recording sensitivity, multiplex index, and storage stability in the same manner as in Example 1.

(Example 3)

An optical recording medium was prepared in the same manner as in Example 1, provided that 4.4 g of the diazonium salt compound (Compound 17) was replaced with 4.1 g of the diazonium salt compound (Compound 7). The prepared optical recording medium was evaluated in terms of recording sensitivity, multiplex index, and storage stability in the same manner as in Example 1.

(Example 4)

An optical recording medium was prepared in the same manner as in Example 1, provided that 4.4 g of the diazonium salt compound (Compound 17) was replaced with 3.9 g of the diazonium salt compound (Compound 15). The prepared optical recording medium was evaluated in terms of recording sensitivity, multiplex index, and storage stability in the same manner as in Example 1.

(Comparative example 1)

An optical recording medium was prepared in the similar manner as in Example 1, provided that a capsule shell material was not added in a coating solution for a recording layer.

Specifically, to 16.1 g of ethyl acetate, there were added 4.4 g of the diazonium salt compound (Compound 17), 4.8 g of squalane, and 4.8 g of monoisopropylbiphenyl, and the mixture was heated at 40°C, and uniformly dissolved to thereby yield the mixed solution (IV).

To the mixed solution (IV), there was added 85 g of 10% by mass polyvinyl alcohol aqueous solution (product name: PVA-105, the manufacturer: KURARAY CO., LTD., saponification degree: 98% to 99%), and the mixture was emulsified and dispersed by means of with a homogenizer (the manufacturer: NISSEI Corp.) at the external temperature of 10°C to thereby obtain an emulsion. To the obtained emulsion, there was added and uniformly mixed 20g of water, the emulsion solution was stirred at the external temperature of 40°C three hours to remove the ethylacetate and to proceed with a reaction. Thereafter, 4.1 g of ion exchange resin Amberlite IRA 68 (by ORGANO Corp.), and 8.2 g of ion exchange resin Amberlite IRC 50 (by ORGANO Corp.) were added thereto, and stirred further for one hour. After stopped stirring, the mixture was subjected to filtration so as to remove the ion exchange resins therefrom, and the water therein was evaporated slowly in order to adjust the solids content of the solution to be 50%, to thereby yield a solution (V) which contains particles each containing the diazonium salt compound. The diameter of the obtained particles was 0.30 μm with Median diameter, and the measurement was taken by a particle size analyzer (product name: LA-700, the manufacturer: Horiba Ltd.).

By using the thus prepared microcapsule solution (V), the optical recording medium was prepared in the same manner as in Example 1. The prepared optical recording medium was evaluated in terms of recording sensitivity, multiplex index, and storage stability in the same manner as in Example 1.a

(Comparative example 2)

A coating solution of a recording layer was prepared in the similar manner as in Example 1, provided that 4.4 g of the diazonium salt compound (Compound 17) was replaced with Compound A represented by the following structural formula, Compound A was dissolved in polyvinyl alcohol aqueous solution so that the mol content of Compound A became the identical to the mol content of the diazonium salt compound in Example 1, and the solids content thereof was adjusted to be 50% to thereby prepare a coating solution for a recording layer.

By using the thus prepared coating solution, the optical recording medium was prepared in the same manner as in Example 1. The prepared optical recording medium was evaluated in terms of recording sensitivity, multiplex index, and storage stability in the same manner as in Example 1.

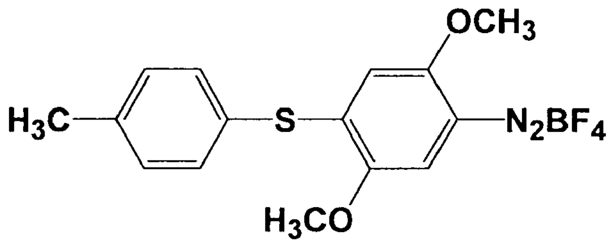

The results of Examples and Comparative Examples are shown in Table 1.

Table 1

| | Initial Property (before storage) | | (a) 40°C, 90%RH after 24 hours storage | | (b) 60°C, 30%RH after 24 hours storage | |
|---|---|---|---|---|---|---|
| | recording sensitivity ($mJ/cm^2$) | multiplex property M | recording sensitivity ($mJ/cm^2$) | multiplex property M | recording sensitivity ($mJ/cm^2$) | multiplex property M |
| Example 1 | 75 | 121 | 75 | 121 | 76 | 121 |
| Example 2 | 75 | 121 | 76 | 121 | 78 | 121 |
| Example 3 | 72 | 121 | 72 | 121 | 72 | 121 |
| Example 4 | 68 | 121 | 68 | 121 | 68 | 121 |
| Comparative Example 1 | 75 | 25 | unable to record | - | unable to record | - |
| Comparative Example 2 | 75 | 81 | unable to record | - | unable to record | - |

(Example 5)

(1) Preparation of a recording layer-coating solution

Described as below, a mixed solution (I), a microcapsule solution (II), and a microcapsule solution (III) were sequentially prepared to yield a recording layer-coating solution.

At first, to 16.1 g of ethyl acetate, there were added 4.3 g of a diazonium salt compound (Compound 17), 6.4 g of squalane, and 3.2 g of monoisopropylbiphenyl, and the mixture was heated at 40°C, and uniformly dissolved. To this mixed solution, there was added 8.6 g of a mixture of xylenediisocyanate-trimethylolpropane adduct and xylenediisocyanate-bisphenol A adduct (product name: Takenate D119N (50% by mass ethylacetate solution), the manufacturer: Takeda Pharmaceutical Co., Ltd.) as a capsule shell material, and the mixture was uniformly stirred uniform to thereby yield the mixed solution (I).

To the mixed solution (I), there were added 5 g of 10% by mass polyvinyl alcohol aqueous solution (product name: PVA-105, the manufacturer: KURARAY CO., LTD., saponification degree: 98% to 99%) and 80 g of 10% by mass silica-modified polyvinyl alcohol aqueous solution (product name: R-1130, the manufacturer: KURARAY CO., LTD., saponification degree: 98% to 99%), and the mixture was emulsified and dispersed by means of with a homogenizer (the manufacturer: NISSEI Corp.) at the external temperature of 10°C to thereby obtain an emulsion. To the obtained emulsion, there was added and uniformly mixed 20 g of water, the emulsion solution was stirred at the external temperature of 40°C for three hours to remove the ethylacetate and to proceed with a capsulation reaction. Thereafter, 4.1 g of ion exchange resin Amberlite IRA 68 (by ORGANO Corp.), and 8.2 g of ion exchange resin Amberlite IRC 50 (by ORGANO Corp.) were added thereto, and stirred further for one hour. After stopped stirring, the mixture was subjected to filtration so as to remove the ion exchange resins therefrom, and the water therein was evaporated slowly in order to adjust the solids content of the solution to be 50%, to thereby yield a microcapsule solution (II) which contains microcapsules each encapsulating the diazonium salt compound. The particle diameter of the obtained microcapsule was 0.21 μm with Median diameter, and the measurement was taken by a particle size analyzer (product name: LA-700, the manufacturer: Horiba Ltd.).

Thereafter, the microcapsule solution (II) was subjected to a classification by centrifugal separation in accordance with the method as described in JP-A 2005-96124 , photographed with scanning electron microscope (SEM), and measured the particle diameter with the photograph analysis to thereby prepare the microcapsule solution (III) having the particle diameter of 0.07 μm with Median diameter (voluminous standard). In this manner, a recording layer-coating solution was prepared as the microcapsule solution (III).

(2) Preparation of a recording layer sheet

On a silicon wafer, four Teflon™ sheets were bonded to form a bank, and a pool for the recording layer-coating solution to be poured was prepared. Specifically, an adhesive was applied as thin and uniform as possible on the Teflon (TM) sheet with 10mm width, 10cm length, and 700 μm thickness, and the pool with 10 cm width and length, and 700

μm depth was built.

Then the microcapsule solution (III) was poured into the pool. The poured amount of the microcapsule solution (III) was determined so that a dried film had a thickness of 100 μm after evaporating 95% of the water from the solution. It was dried under the condition of the temperature at 40°C, and the relative humidity at 30% to thereby yield a sheet having a thickness of 100 μm ± 2 μm. This procedure was repeated five times in order to obtain a recording layer sheet having a thickness of 500 μm. The recording layer sheet is cut and peeled out so as to have a cross section area of 5cm x 5cm to thereby obtain a recording layer sheet. Thus obtained recording layer sheet was subjected to the measurement of an oxygen permeability coefficient in accordance with a high vacuumed pressure method (Temperature: 23°C, Humidity: 50%RH), and it was found that the oxygen permeable coefficient thereof was 0.28 ml ·25μm/$m^2$ ·24h atm.

Thereafter, an optical recording medium was prepared in the same manner as in Example 1.

By means of a collinear hologram recording and reproducing examiner SHOT-1000 produced by PULSTEC INDUSTRIAL CO., LTD., the prepared optical recording medium was subjected to a writing of a series of multiplex holograms with a recording spot diameter of 200 μm at the focal point of the hologram recording in the same manner as in Example 1. The recorded holograms were measured and evaluated in terms of photosensitivity (recording energy), multiplex index and storage stability in the same manner as in Example 1. Regarding the raw material storage stability of the optical recording medium (storage stability before practical use), it was found that, compared to the multiplex property M of 30 before the storage, the optical recording medium maintained its multiplex property M as 30 even after the storage under the conditions of both (a) and (b).

<Fixability of the optical recording medium>

The entire surface of the recording layer of the optical recording medium after the multiplex recording was irradiated with the light emitted from a fluorescence lamp with radiation power of 35mJ/$cm^2$ and a wavelength of 365 nm, so as to optically decompose the remained diazonium salt compound completely to thereby perform the fixing on the optical recording medium. The reproduction error after the fixing wax kept at BER > $10^{-3}$, and almost the same result to that of the optical recording medium without being fixed. Note that, the completion of the decomposition of the diazonium salt compound was confirmed by measuring the absorption spectrum of the diazonium salt compound.

Thereafter, the reproduction light was integrally irradiated 100 times by every 10 seconds. The optical recording medium, which had not been fixed, gradually showed disturbed reproduced image in which a dark part of the reproduction image started to appear to be brighter. The optical recording medium, which had been fixed, did not show any disturbance in the reproduced image even after the integral radiation of the reproduction light.

(Example 6)

An optical recording medium was prepared in the same manner as in Example 5, provided that 4.3 g of the diazonium salt compound (Compound 17) was replaced with 4.1 g of the diazonium salt compound (Compound 1). The prepared optical recording medium was evaluated in terms of recording sensitivity, multiplex index, and storage stability in the same manner as in Example 5. Moreover, an oxygen permeability coefficient of the recording layer sheet of the optical recording medium was measured in the same manner as in Example 5, and it was found that the oxygen permeable coefficient thereof was 0.28 ml ·25μm/$m^2$·24h·atm.

(Example 7)

An optical recording medium was prepared in the same manner as in Example 5, provided that 4.3 g of the diazonium salt compound (Compound 17) was replaced with 4.1 g of the diazonium salt compound (Compound 7). The prepared optical recording medium was evaluated in terms of recording sensitivity, multiplex index, and storage stability in the same manner as in Example 5. Moreover, an oxygen permeability coefficient of the recording layer sheet of the optical recording medium was measured in the same manner as in Example 5, and it was found that the oxygen permeable coefficient thereof was 0.28 ml ·25μm/$m^2$ ·24h ·atm.

(Example 8)

An optical recording medium was prepared in the same manner as in Example 5, provided that 4.3 g of the diazonium salt compound (Compound 17) was replaced with 3.8 g of the diazonium salt compound (Compound 15). The prepared optical recording medium was evaluated in terms of recording sensitivity, multiplex index, and storage stability in the same manner as in Example 5. Moreover, an oxygen permeability coefficient of the recording layer sheet of the optical recording medium was measured in the same manner as in Example 5, and it was found that the oxygen permeable coefficient thereof was 0.28 ml·25μm/$m^2$·24h·atm.

(Example 9)

An optical recording medium was prepared in the same manner as in Example 5, provided that 4.3 g of the diazonium salt compound (Compound 17) was replaced with 4.1 g of the diazonium salt compound (Compound 35). The prepared optical recording medium was evaluated in terms of recording sensitivity, multiplex index, and storage stability in the same manner as in Example 5. Moreover, an oxygen permeability coefficient of the recording layer sheet of the optical recording medium was measured in the same manner as in Example 5, and it was found that the oxygen permeable coefficient thereof was 0.28 ml·25μm/$m^2$·24h·atm.

(Example 10)

An optical recording medium was prepared in the same manner as in Example 5, provided that 4.3 g of the diazonium salt compound (Compound 17) was replaced with 4.1 g of the diazonium salt compound (Compound 36). The prepared optical recording medium was evaluated in terms of recording sensitivity, multiplex index, and storage stability in the same manner as in Example 5. Moreover, an oxygen permeability coefficient of the recording layer sheet of the optical recording medium was measured in the same manner as in Example 5, and it was found that the oxygen permeable coefficient thereof was 0.28 ml·25μm/$m^2$·24h·atm.

(Example 11)

A recording layer sheet was prepared in the same manner as in Example 5, provided that 5 g of 10% by mass polyvinyl alcohol aqueous solution (product name: PVA-105, the manufacturer: KURARAY CO., LTD., saponification degree: 98% to 99%) and 80 g of 10% by mass silica-modified polyvinyl alcohol aqueous solution (product name: R-1130, the manufacturer: KURARAY CO., LTD., saponification degree: 98% to 99%) was replaced with 85 g of 10% by mass polyvinyl alcohol aqueous solution (product name: PVA-105, the manufacturer: KURARAY CO., LTD., saponification degree: 98% to 99%). Thus obtained recording layer sheet was subjected to the measurement of an oxygen permeability coefficient in accordance with a high vacuumed pressure method (Temperature: 23°C, Humidity: 50%RH), and it was found that the oxygen permeable coefficient thereof was 4.1 ml ·25μm/$m^2$·24h·atm.

By using the thus prepared recording layer sheet, an optical recording medium was prepared in the same manner as in Example 1. The prepared optical recording medium was evaluated in terms of recording sensitivity, multiplex index, and storage stability in the same manner as in Example 5.

The results of Examples 6-11 are shown in Table 2. Likewise Example 6, in Examples 7-10, the optical recording medium, which had been fixed, did not show any disturbance in the reproduced image even after the integral radiation of the reproduction light.

Table 2

| | Initial Property (before storage) | | (a) 40°C, 90% after 24 hours storage | | (b) 60°C, 30% after 24 hours storage | |
|---|---|---|---|---|---|---|
| | recording sensitivity (mJ/$cm^2$) | multiplex property M | recording sensitivity (mJ/$cm^2$) | multiplex property M | recording sensitivity (mJ/$cm^2$) | multiplex property M |
| Example 5 | 75 | 169 | 75 | 169 | 76 | 169 |
| Example 6 | 75 | 169 | 76 | 169 | 78 | 169 |
| Example 7 | 72 | 169 | 72 | 169 | 72 | 169 |
| Example 8 | 68 | 169 | 68 | 169 | 68 | 169 |
| Example 9 | 65 | 169 | 65 | 169 | 65 | 169 |
| Example 10 | 62 | 169 | 62 | 169 | 62 | 169 |
| Example 11 | 75 | 121 | 75 | 121 | 76 | 121 |

The optical recording medium of the present invention utilizes variations of the refractive-index of the materials contained in the recording layer, and is excellent in raw material storage stability of the optical recording medium, resolution, diffraction efficiency and the like. Therefore, the optical recording medium of the present invention is suitably applicable for a relatively thin flat hologram which records two-dimensional information, volume hologram which records

a large volume of information such as three-dimensional information, transmittance or reflective hologram, or the like. The optical recording method of the present invention utilizes variations of the refractive-index of the materials contained in the recording layer, and is excellent in raw material storage stability of the optical recording medium, resolution, diffraction efficiency and the like. Therefore, the optical recording medium of the present invention is suitably applicable for various holographic methods capable of recording high-density holograms, such as amplitude hologram, phase hologram, blazed hologram, or multi-element amplitude hologram.

**Claims**

**1.** An optical recording medium, comprising:

a substrate; and
a recording layer disposed on the substrate, the recording layer being subjected to recording of information using holography,
wherein the recording layer comprises a gas generating substance encapsulated in a minute receptacle, and wherein the gas generating substance generates gas upon radiation of light.

**2.** The optical recording medium according to claim 1, wherein the recording layer has an oxygen permeability coefficient of 0.3ml·25μm/m$^2$·24h ·atm or less under the conditions of a temperature at 23°C and a relative humidity at 50%.

**3.** The optical recording medium according to any one of claims 1 to 2, wherein the gas generating substance is a refractive-index changeable material which generates gas within the recording layer upon radiation and changes a refractive-index of the recording layer where the light is irradiated.

**4.** The optical recording medium according to claim 3, wherein the refractive-index changeable material is a diazonium salt compound.

**5.** The optical recording medium according to any one of claims 1 to 4, wherein the minute receptacle is a microcapsule.

**6.** The optical recording medium according to claim 5, wherein a diameter of the microcapsule is the same length to or smaller than a wavelength of the light.

**7.** The optical recording medium according to claim 5, wherein the diameter of the microcapsule is 0.4 μm or less.

**8.** The optical recording medium according to any one of claims 4 to 7, wherein the diazonium salt compound is a diazonium salt comprising at least one substituent, and the substituent is an electron donor group having a negative value of Hammett $\sigma_p$.

**9.** The optical recording medium according to any one of claims 1 to 8, wherein the recording layer further comprises a binder resin, and a content of the binder resin is 10% by mass to 95% by mass with respect to the total solids content of the recording layer.

**10.** An optical recording method, comprising;
irradiating information light and reference light to the optical recording medium according to any one of claims 1 to 9 in a manner such that an optical axis of the information light and an optical axis of the reference light become collinear.

**11.** The optical recording method according to claim 10, further comprising, after said irradiating the information light and the reference light, irradiating incoherent light so as to decompose the remained gas generating substance in the recording layer.

**12.** An optical information reproducing method, comprising;
irradiating reference light to an interference image formed in a recording layer of an optical recording medium in accordance with the optical recording method according to any one of claims 10 to 11, so as to reproduce a recorded information corresponding to the interference image.

**13.** The optical information reproducing method according to claim 12, wherein the reference light for reproducing is

irradiated at the same angle as an angle of the reference light irradiated at the time of recording, so as to reproduce the recorded information.

FIG. 1

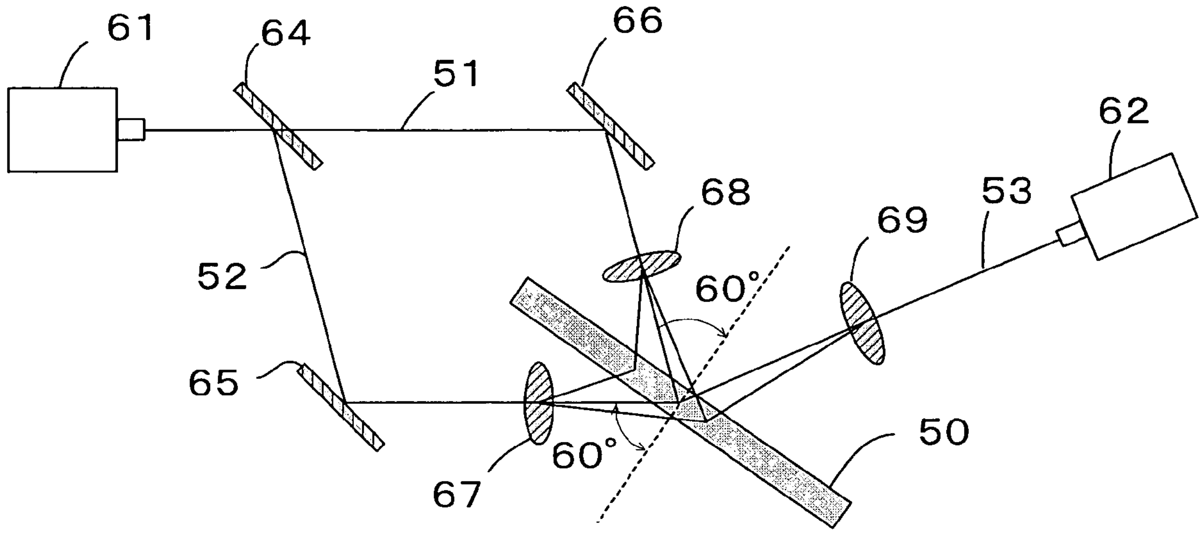


FIG. 2

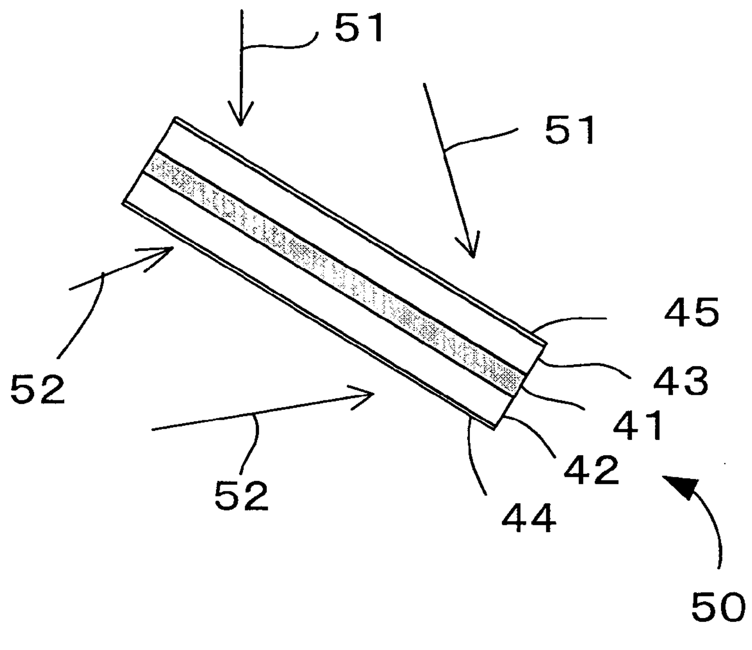

FIG. 3

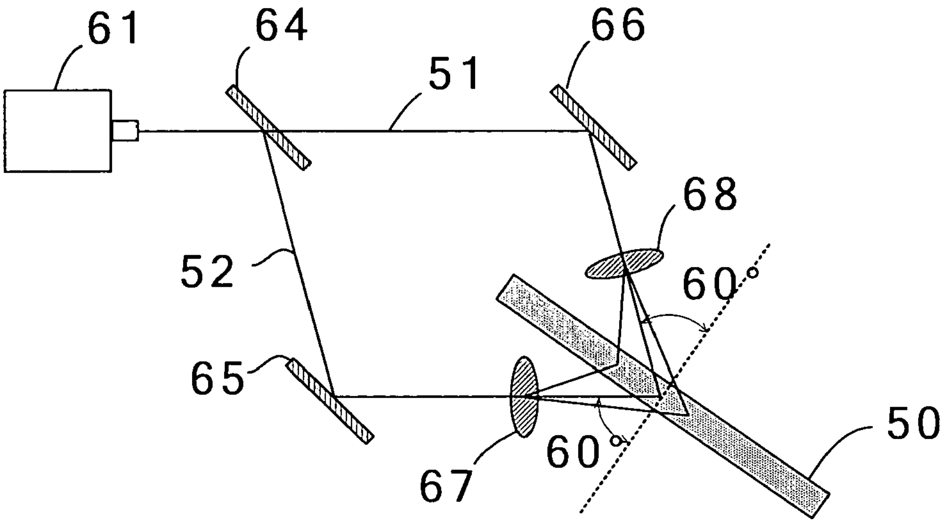


FIG. 4

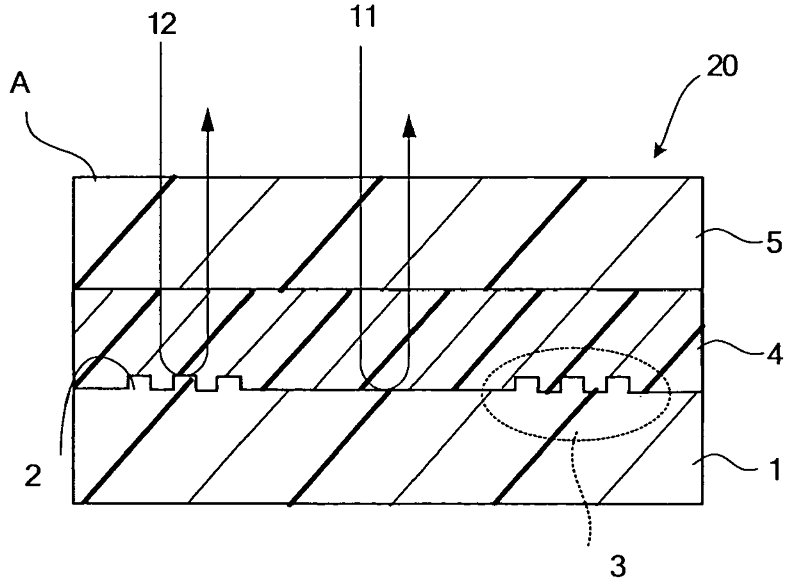

FIG. 5

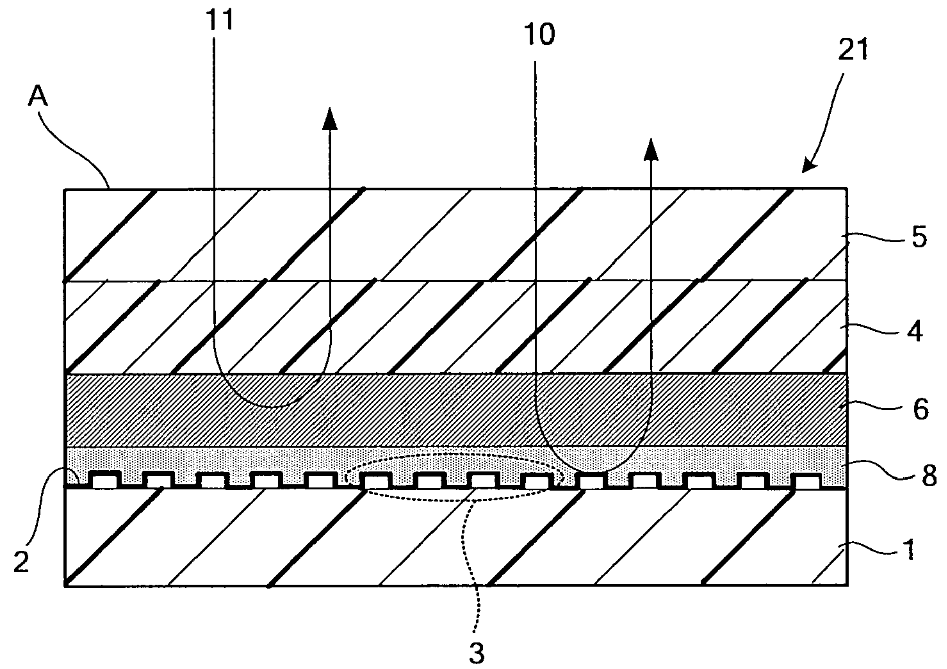


FIG. 6

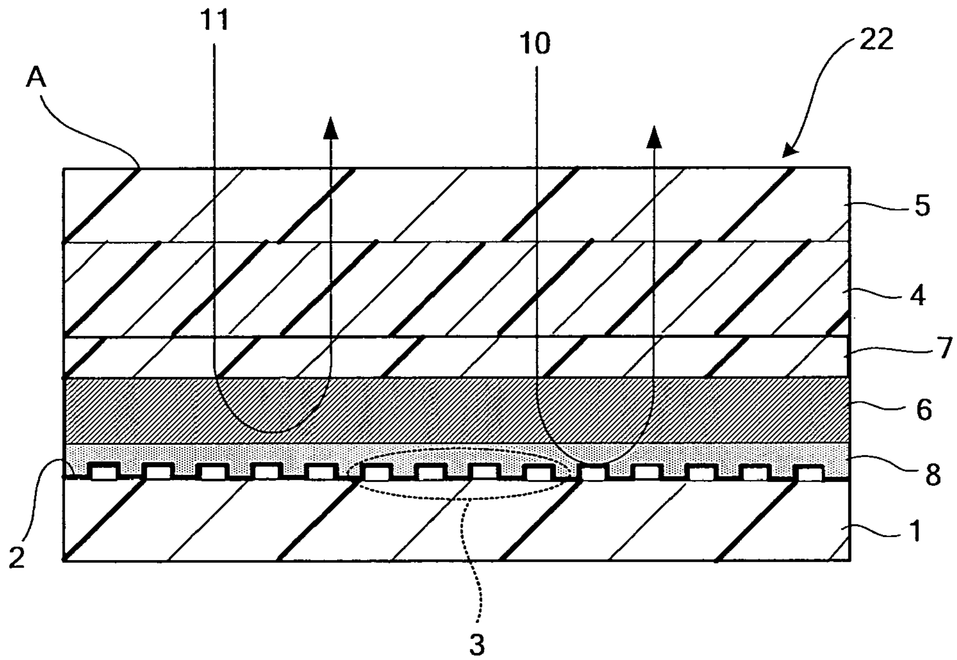

FIG. 7

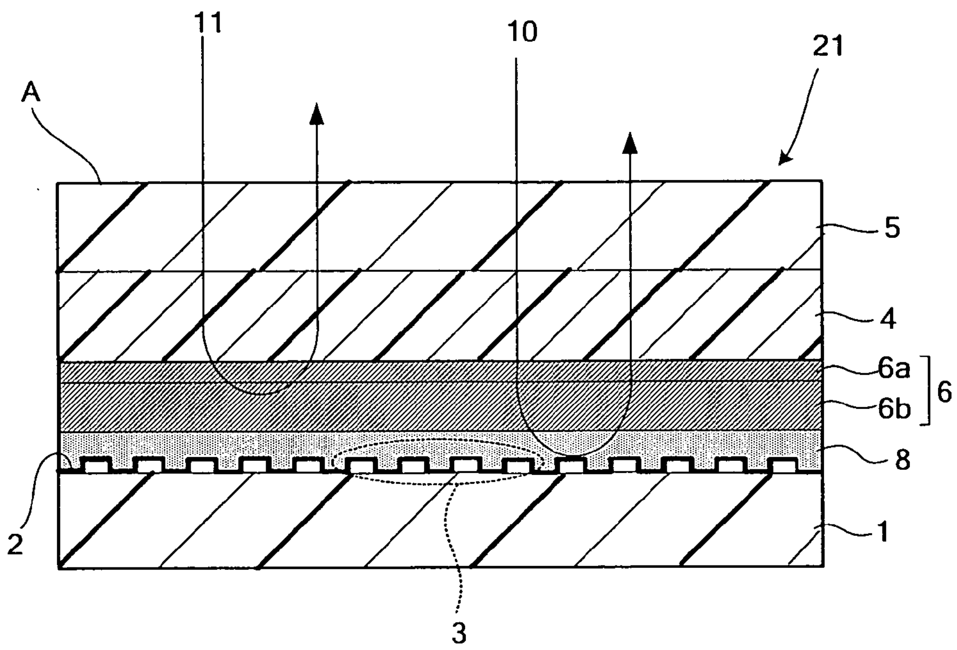


FIG. 8

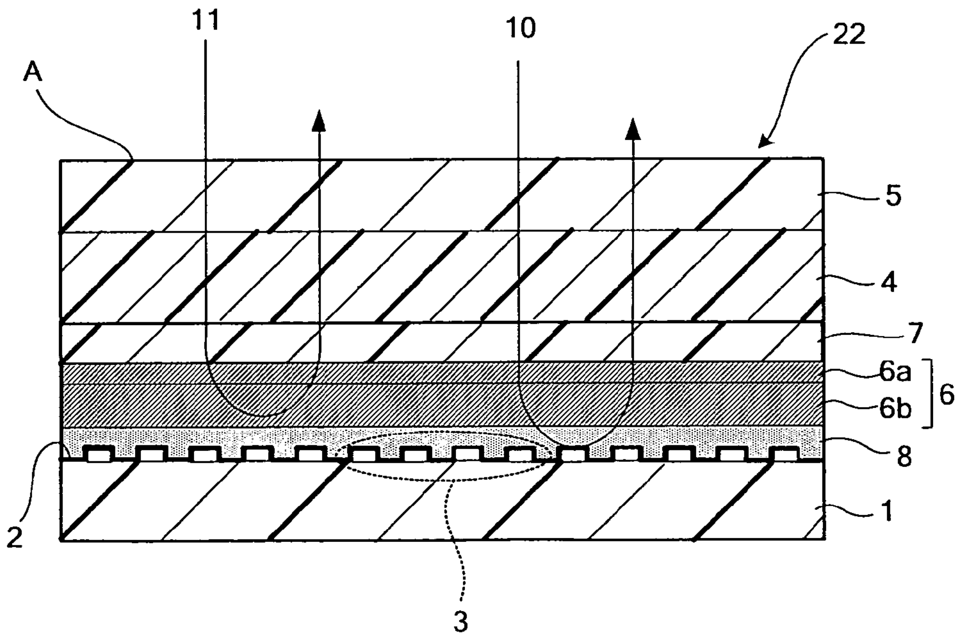

FIG. 9

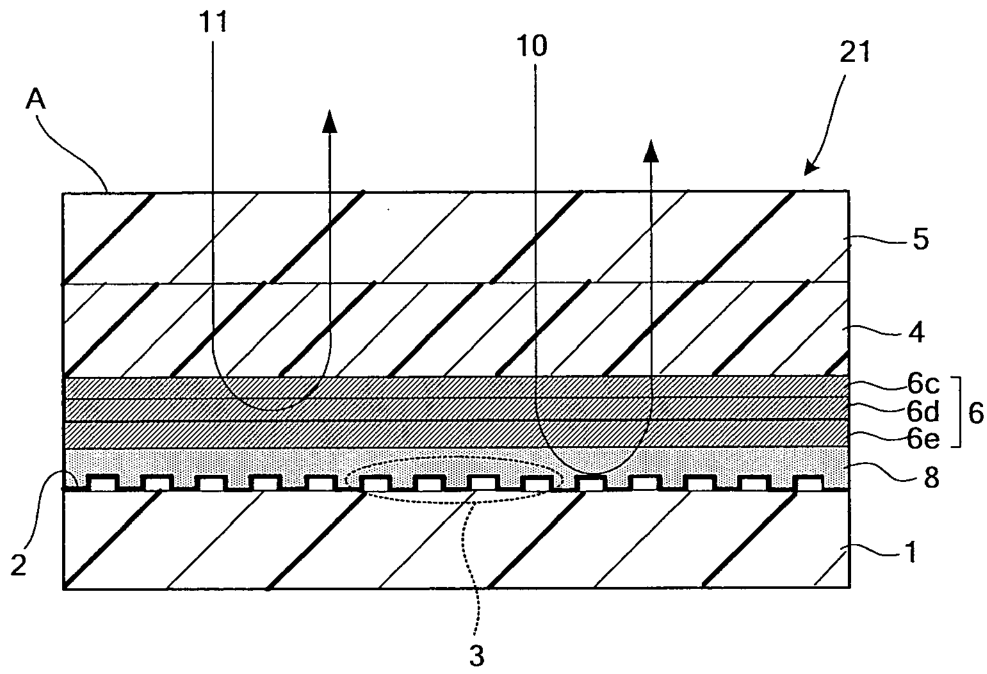


FIG. 10

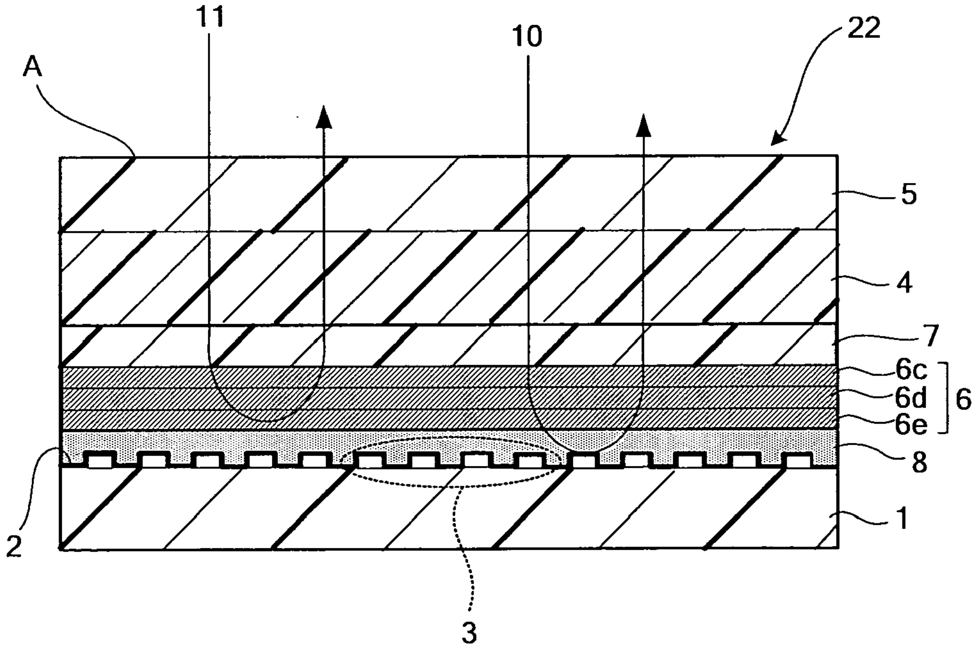

FIG. 11

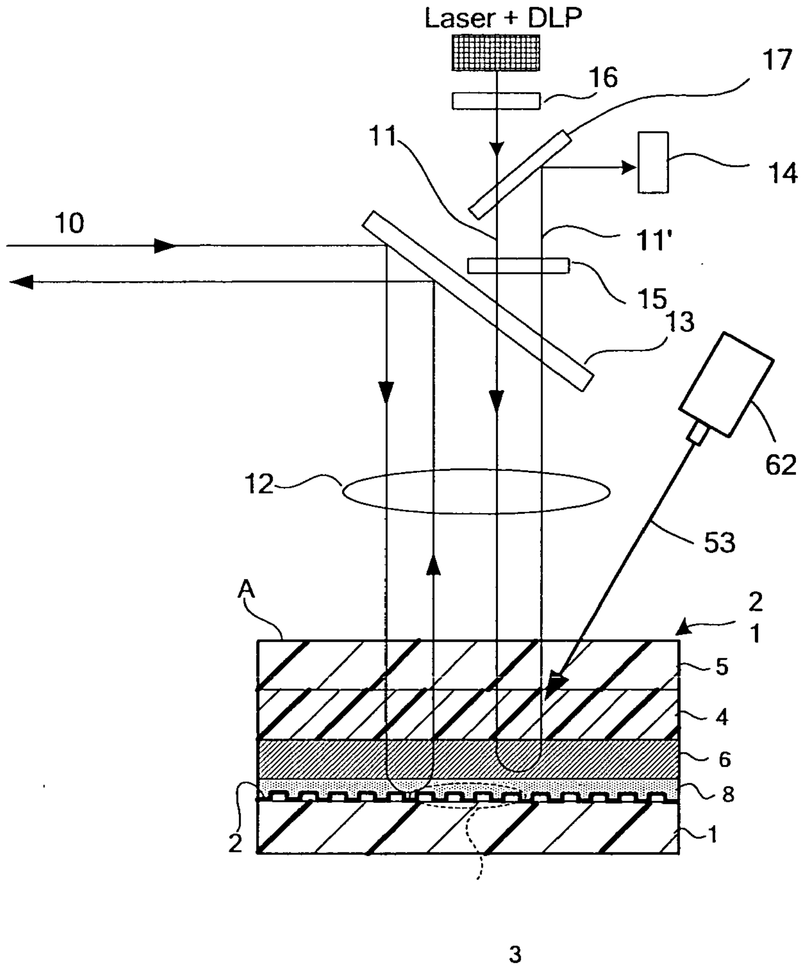

FIG. 12

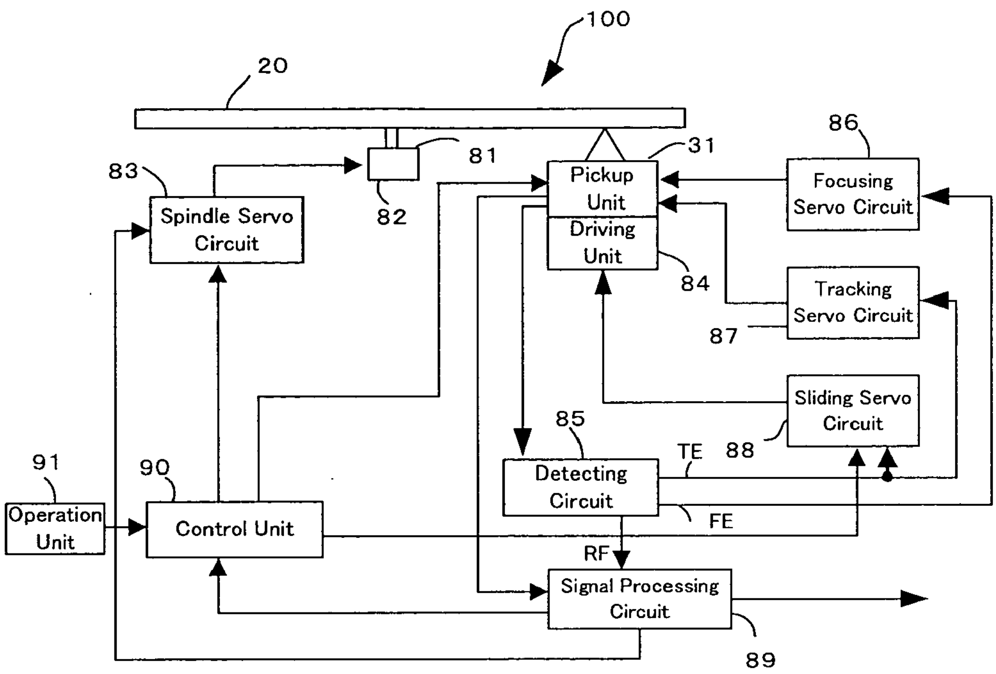
100
20
86
81
31
83
Pickup Unit
Focusing Servo Circuit
Spindle Servo Circuit
82
Driving Unit
84
Tracking Servo Circuit
87
Sliding Servo Circuit
85
TE
88
91
90
Detecting Circuit
Operation Unit
Control Unit
FE
RF
Signal Processing Circuit
89

FIG. 13

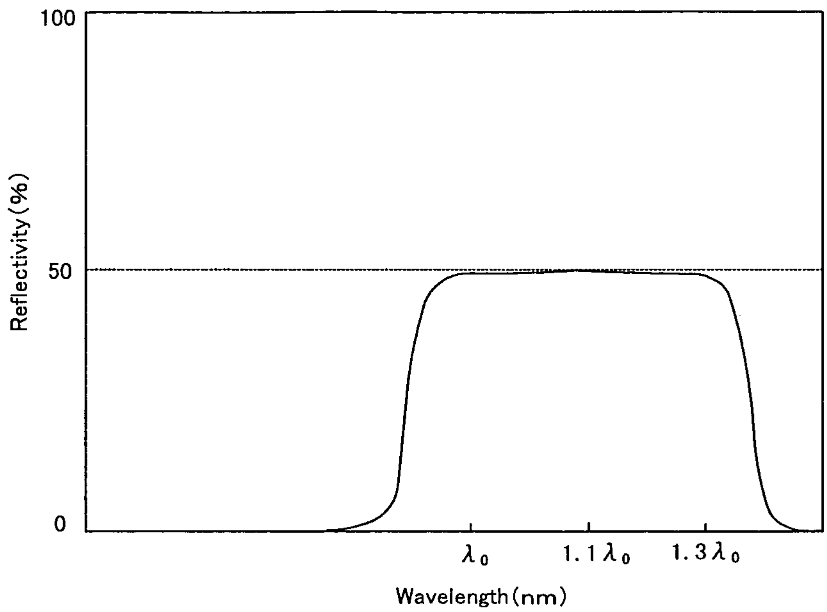
100
50
0
Reflectivity (%)
λ0
1.1λ0
1.3λ0
Wavelength (nm)

FIG. 14

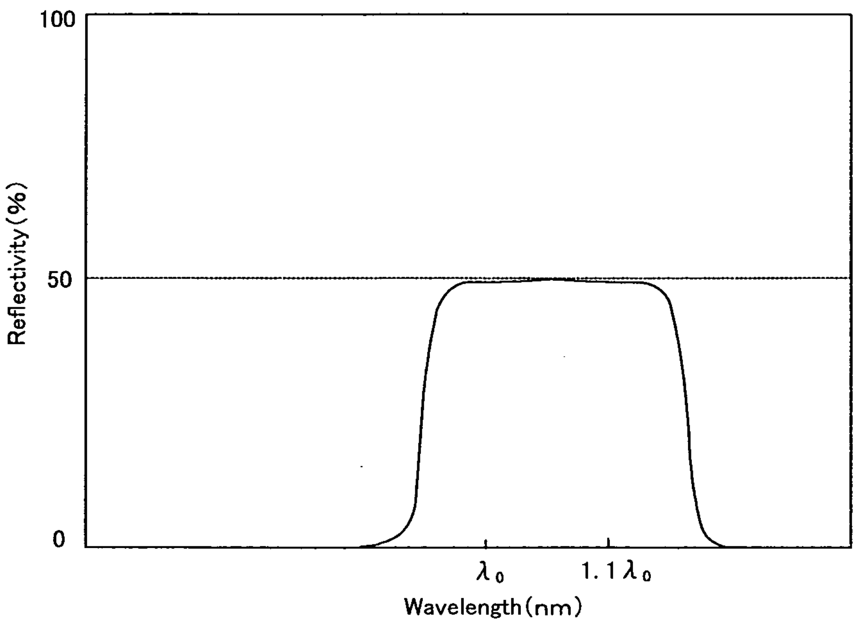
100
50
0
Reflectivity (%)
λ0
1.1λ0
Wavelength (nm)

FIG. 15

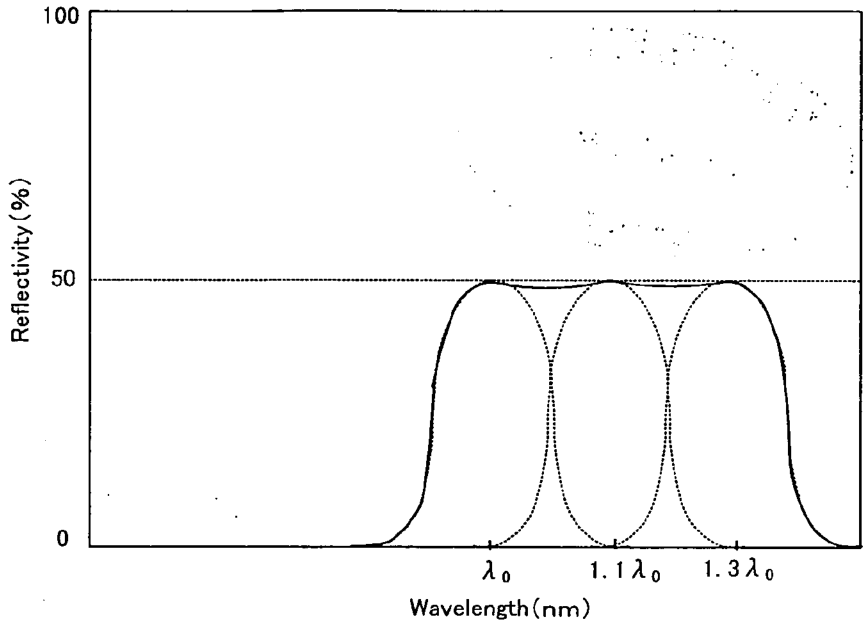
100
50
0
Reflectivity(%)
λ0
1.1λ0
1.3λ0
Wavelength(nm)

FIG. 16

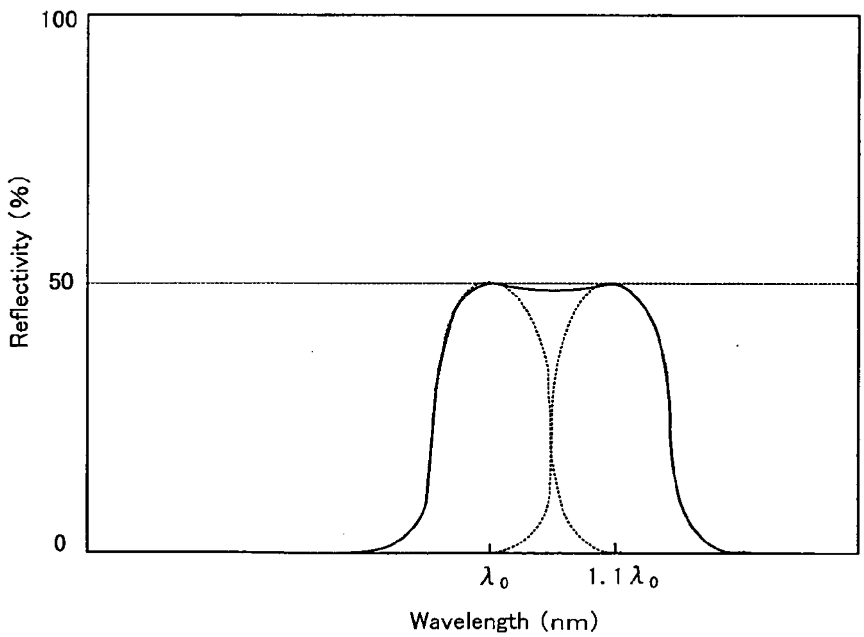
100
50
0
Reflectivity (%)
λ0
1.1λ0
Wavelength (nm)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5072727 A
- JP 2005096124 A
- US 3726804 A
- US 3796669 A
- JP 62212190 A
- JP 4026189 A
- JP 5317694 A
- JP 8268721 A
- JP 2004352081 A
- JP 47010537 A
- JP 58111942 A
- JP 58212844 A
- JP 59019945 A
- JP 59046646 A
- JP 59109055 A
- JP 63053544 A
- JP 3610466 B
- JP 4226187 B
- JP 48030492 B
- JP 48031255 B
- JP 48041572 B
- JP 48054965 B
- JP 50010726 B
- US 2719086 A
- US 3707375 A
- US 3754919 A
- US 4220711 A


### Non-patent literature cited in the description


- **KEIJI IWATA.** Polyurethane handbook. NIKKAN KOGYO SHIMBUN LTD, 1987
- *ISOM '04,* October 2004, 184-185